(19) Europäisches Patentamt
European Patent Office
Office européen des brevets

(11) EP 0 463 067 B1

# (12) EUROPEAN PATENT SPECIFICATION

(45) Date of publication and mention
of the grant of the patent:
**05.06.1996 Bulletin 1996/23**

(51) Int Cl.[6]: **H01L 29/36**, H01L 29/10,
H01L 29/78, H01L 29/49

(21) Application number: **90905155.9**

(22) Date of filing: **01.03.1990**

(86) International application number:
**PCT/US90/01158**

(87) International publication number:
**WO 90/10309 (07.09.1990 Gazette 1990/21)**

(54) **FERMI THRESHOLD FIELD EFFECT TRANSISTOR**

FELDEFFEKTTRANSISTOR MIT FERMI-SCHWELLENSPANNUNG

TRANSISTOR A EFFET DE CHAMP A SEUIL DE FERMI

(84) Designated Contracting States:
**AT BE CH DE DK ES FR GB IT LI LU NL SE**

(30) Priority: **02.03.1989 US 318153**
**22.06.1989 US 370398**

(43) Date of publication of application:
**02.01.1992 Bulletin 1992/01**

(73) Proprietor: **THUNDERBIRD TECHNOLOGIES, INC.**
**Cary, NC 27511 (US)**

(72) Inventor: **VINAL, Albert, W.**
**Cary, NC 27511 (US)**

(74) Representative: **Warren, Keith Stanley et al**
**BARON & WARREN**
**18 South End**
**Kensington**
**London W8 5BU (GB)**

(56) References cited:
EP-A- 0 031 238    EP-A- 0 056 856
EP-A- 0 070 744    EP-A- 0 071 335
EP-A- 0 073 623    EP-A- 0 099 787
EP-A- 0 110 103    EP-A- 0 274 278
DE-A- 3 138 747    US-A- 3 872 491
US-A- 4 042 945    US-A- 4 108 686
US-A- 4 243 997

- **Proceedings IEEE International Conference on Computer Design: VLSI in Computers,Port Chester, New York, 7-10 October 1985, IEEE, (US), S.J. HILLENIUS et al.: "Gate Material Work Function Considerations for 0.5 Micron CMOS", pages 147-150 see Abstract; figure 3, curve No. 7; paragraph 2**
- **International Electron Devices Meeting, Washington, DC, 5-7 December 1983, Technical Digest, IEEE, (US), S.-Y. CHIANG et al.: "Optimization of Sub-Micron P-Channel FET Structure", pages 534-537 see Abstract; figures; page 534, column**
- **International Electron Devices Meeting, Washington, DC, 8-10 December 1980, Technical Digest, IEEE (US), E. SUN et al.: "The Junction MOS (JMOS) Transistor - A High Speed Transistor for VLSI", pages 791-794 see Abstract; page 791, column 2,lines 10-39; figures 1,2 cited in the application**
- **Solid State Electronics, Volume 15, No. 11-E, November 1972, Pergamon Press, (Oxford, GB) M. HSWE et al.: "Characteristics of p-Channel MOS Field Effect Transistors with Ion-Implanted Channels", pages 1237-1243 see Abstract; table 2; figure 1; paragraphs 3.1, 3.3**
- **Japanese Journal of Applied Physics Supp., Volume 15, No. 7, 1976, (Tokyo, JP), RYOICHI HORI et al.: "Short Channel MOS-IC Based on Accurate Two Dimensional Device Design", page 193-199, see Abstract; page 195, column 2 - page 198, column 1**

- Electronics, Volume 43, No. 23, 9 November 1970, (New York, US), "Slight Change
- Increases Breakdown Voltage", see page 28, column 2

- PATENT ABSTRACT OF JAPAN, Volume 9, No. 305 (E-363) (2028), 3 December 1985, & JP, A, 60143671

## Description

This invention relates to field effect transistor devices, and more particularly to high speed field effect transistors having operational characteristics which are independent of device dimensions, operating temperature and doping concentrations.

Field Effect Transistors (FET's) have become the dominant active device for Very Large Scale Integration (VLSI) and Ultra Large Scale Integration (ULSI) applications, because the integrated circuit FET is by nature a high impedance, high density, low power device. Much research and development activity has focused on improving speed and density of FETs, and on lowering the power consumption thereof.

As is well known to those having skill in the art there are two types of FET devices: the Insulated Gate FET (IGFET) and the Junction FET (JFET). Most present day integrated circuit technology employs the IGFET because of its simplified construction for integrated circuit applications. An IGFET typically comprises source and drain regions in a semiconductor substrate at a first surface thereof, and a gate region therebetween. The gate comprises an insulator on the first substrate surface between the source and drain regions, with a gate electrode or contact on the insulator. A channel is formed in the semiconductor substrate beneath the gate electrode, and the channel current is controlled by a voltage at the gate electrode.

In the most common configuration of an IGFET, an oxide layer is grown or otherwise formed on the first semiconductor surface, between the source and drain regions, and a metal or other gate electrode is formed on the oxide layer. This structure is commonly called a Metal Oxide Semiconductor Field Effect Transistor (MOS or MOSFET). The terms MOS and MOSFET are now used interchangeably with IGFET to include devices in which the insulator is a material other than an oxide (for example a nitride), and the gate electrode is a material other than metal (for example polysilicon). These terms will be used interchangeably herein.

Two types of channels may be provided in MOS devices. The first is referred to as an "induced channel", in which gate voltage induces a field in the substrate under the gate to thereby draw electrons (for a P-type substrate) into the region beneath the gate. As a result, this region changes conductivity type (e.g. P-type to N-type), and an induced channel is formed. The induced change of semiconductor material from one conductivity type to opposite conductivity type is called "inversion". Increasing gate voltage enhances the availability of electrons in the channel, so that an induced channel MOS device is referred to as operating in an "enhancement" mode.

The second type of channel is a "diffused channel" in which a channel having conductivity opposite that of the substrate is formed beneath the gate electrode. In such a device current flows between source and drain even in the absence of gate voltage. Decreasing gate voltage causes current to decrease as the diffused channel is depleted of carriers. Increasing gate voltage causes the gate current to increase as the diffused channel is enhanced. Accordingly, a diffused channel MOS device may operate in "enhancement" or "depletion" modes.

Enhancement mode (induced channel) devices are preferred for digital integrated circuit applications because these devices are off at zero gate voltage. Both enhancement and depletion mode devices have a threshold voltage associated therewith. The threshold voltage is the value of gate voltage needed to initiate device conduction. Threshold voltage is an important MOS characteristic and must be well controlled to provide satisfactory integrated circuit devices.

Unfortunately, the threshold voltage of known MOS devices typically varies as a function of the oxide thickness, the length of the channel, drain voltage, and the substrate doping concentration. Since each of these parameters can vary dramatically from one integrated circuit to another, very strict manufacturing tolerances (often referred to as "groundrules") must be provided to ensure device uniformity. However, strict manufacturing ground rules lower device yields. Moreover, since device dimensions and doping levels become more difficult to control as the devices become smaller, increases in device density and operating speed are difficult to obtain.

The threshold voltage of conventional MOS devices also varies as a function of device temperature. Unfortunately, device operating temperature varies considerably from one integrated circuit to another, depending upon the application. In fact, operating temperatures vary considerably within an integrated circuit, depending upon the duty cycle of the individual devices. MOS devices must be designed to operate properly despite the variation in threshold voltage with temperature. As such, lower performance and lower speed must be specified to ensure proper operation at all operating temperatures.

Many techniques have been proposed in an attempt to control threshold voltage while maintaining acceptable process groundrules; however such techniques cannot fully overcome the inherent variability of threshold voltage in the conventional FET structure. Other attempts have been made to improve the basic structure of the FET to provide improved characteristics. For example, a publication entitled *A Normally-Off Type Buried Channel MOSFET For VLSI Circuits,* by K. Nishiuchi et al. (IEDM Technical Digest, 1979, pages 26-29) discloses a buried channel MOSFET that uses a bulk region as a conducting channel in contrast with the surface channel of a conventional device. Another publication entitled *The Junction MOS (JMOS) Transistor - A High Speed Transistor For VLSI,* by E. Sun et al. (IEDM Digest, 1980, pages 791-794) discloses a MOS device using a layered N-P P-junction structure beneath a MOS gate region.

German Offenlegungsschrift DE-A-31 38 747, published 14 March, 1983, describes a depletion mode field effect transistor which includes additional semiconductor regions **11** and **12** below the source and drain regions **2** and **3** respectively, and adjacent thereto, which form a common substantially flat p-n junction **13** with the adjoining portion of the semiconductor substrate **1**. The dependence of the device's threshold voltage on the channel length is thereby reduced for short channel FET devices.

The art has heretofore not exhaustively investigated the origin of threshold voltage in FETs and the reasons for variation of threshold voltage with device characteristics. Accordingly, the art has heretofore not provided an FET design which minimizes variations of threshold voltage by eliminating those characteristics which contribute to this variation.

Miniaturization of MOS devices for VLSI and ULSI designs has also created other problems. For example, short channel devices are increasingly prone to breakdown due to well known punch-through and impact ionization effects. In order to prevent such breakdown, short channel devices have employed scaled down input (supply) voltage, for example 3V instead of the standard 5V supplies heretofore employed. However, as is well known to those having skill in the art, decreasing supply voltage causes threshold voltage to become a greater fraction of the supply voltage, thereby reducing device speed and negating the advantage of short channel devices.

Finally, as device density further increases, it has become more difficult to provide ohmic (i.e. non-rectifying) contacts to these devices. Complex contact metallurgy schemes have been developed in an attempt to provide satisfactory, high density ohmic contacts. Complex contact metallurgy creates manufacturing problems and cannot fully compensate for poor ohmic contacts themselves.

The present invention consists in a field effect transistor comprising:

a semiconductor substrate of first conductivity type having a first surface and being doped at a first dopant density $N_s$, said semiconductor substrate having an intrinsic carrier concentration $N_i$ at temperature T degrees Kelvin, and a dielectric constant $e_s$;

source and drain regions of second conductivity type in said substrate at said first surface;

at least one channel of said second conductivity type in said substrate at said first surface between said source and drain regions, said at least one channel being doped at a second dopant density;

a gate insulating layer on said substrate at said first surface adjacent said at least one channel; and

source and drain contacts and at least one gate contact for contacting said source and drain regions and said gate insulating layer respectively,

characterised in that said second dopant density is a factor $\propto$ times said first dopant density $N_s$, said at least one channel having a predetermined depth $Y_o$ from said first surface, with $Y_o$ being equal to

$$\sqrt{2e_s(\phi_s+|V_{substrate}|))/(qN_s\alpha(\alpha+1))}$$

where $\phi_s$ is equal to $(KT/q)1n(N_s/N_1)^2+(KT/q)1n\propto$, q is equal to $1.6 \times 10^{-19}$ coulombs, K is equal to $1.38 \times 10^{-23}$ Joules/°Kelvin, and $V_{substrate}$ is the substrate bias voltage, if applied.

Said first and second dopant densities, the source doping, the drain doping and said predetermined depth may be selected to produce zero static electric field perpendicular to said first surface at said first surface between said at least one channel and said gate insulating layer at the threshold voltage of said field effect transistor.

The invention enables the manufacture of high density high speed MOS devices with relaxed ground rules thereby to increase device yields.

Furthermore, it enables the provision of high density MOS devices which operate at full supply voltage without the risk of breakdown due to punch through or impact ionization.

By setting the transistor's threshold voltage to twice the Fermi potential of the semiconductor material, the device operates in the enhancement mode without requiring inversion. As is well known to those having skill in the art, Fermi potential is defined as that potential for which a semiconductor material has a probability of one half of being occupied by an electron. Accordingly, the FET device according to the present invention may be referred to as a Fermi Threshold FET or Fermi-FET.

It has been found that when the threshold voltage is set to twice the Fermi potential, the dependence of the threshold voltage on oxide thickness, channel length, drain voltage and substrate doping is eliminated. It has also been found that when the threshold voltage is set to twice the Fermi potential, the vertical electric field at the first surface of the semiconductor substrate in the channel is minimized, and is in fact substantially zero. Carrier mobility in the channel is thereby maximized, leading to a high speed MOS device with greatly reduced hot electron effects.

Stated another way, it has been found that dependence of threshold voltage on oxide thickness, channel length, drain voltage and doping level is a result of the voltage developed across the gate oxide layer which is necessary to establish inversion in conventional MOSFET's. According to the invention, by providing a threshold voltage equal to twice the Fermi potential, inversion is prevented, leading to a high speed device substantially independent of device dimensions.

In a preferred embodiment of the invention it has been found that the above described Fermi-FET criteria may be met by forming a contra doped channel region having a carrier concentration or dopant density $\alpha$ times the dopant density of the substrate and having a channel depth $Y_0$ which is specified as:

$$Y_0 = \sqrt{\frac{2e_s\,\phi_s}{q\,N_s\,\alpha\,(\alpha+1)}}$$

where $e_s$ is the dielectric constant of the semiconductor material (Farads/cm), q is the electric charge ($1.6 \times 10^{-19}$C), and $N_s$ is the substrate doping density.

It has been found that the contact potentials (referred to as a "flat-band voltages") generated by conventional FET substrate and gate contacts may adversely effect the threshold voltage of FET devices, in a manner not accounted for in previous FET designs. According to a feature of the invention it has been found that the FET gate contact may be selected to be a semiconductor having a conductivity type and dopant density which generates a gate contact potential which is equal and opposite to that of the substrate contact potential, thereby neutralizing the effect of flat-band voltages. Dependence of threshold voltage on temperature is thereby eliminated. In order to neutralize the substrate flat band voltage, the gate electrode is selected to be the same semiconductor as the substrate, having the same conductivity type and similar doping density as the substrate. In a preferred embodiment, when the substrate is monocrystalline silicon, the gate electrode is polysilicon.

Flat-band voltage compensation may be employed to improve the performance of conventional FET's, to make P- and N-channel threshold voltages symmetric and less dependent upon temperature. Moreover, since the threshold voltage of the Fermi-FET is already independent of other device parameters, the use of flat-band voltage compensation further enhances the performance thereof.

Conventional high density FET devices have shallow channels and relatively deep diffusions which place severe constraints on means to control punch-through. With the invention, the Fermi-FET criteria described above may be maintained, while allowing for a deep, channel by providing a substrate contact for the Fermi-FET and applying a substrate bias on this contact. For N-channel Fermi-FETs a negative substrate bias is applied, while for P-channel Fermi-FETs, a positive substrate bias is applied. In the presence of a substrate voltage bias $V_{sub}$, the channel depth which satisfies the Fermi-FET criteria becomes:

$$Y_0 = \sqrt{\frac{2e_s\,(\phi_s + |V_{sub}|)}{q\,N_s\,\alpha\,(\alpha+1)}}$$

Accordingly, deep channels may be provided, with the resultant ease of manufacturability.

It has also been found that with substrate bias the deep channel produces increased drain conductance at low values of drain voltage. Since the source and drain depths are also preferably increased to maintain depth equality with the channel, source and drain resistance is also decreased. Diffusion capacitance and gate capacitance also decreases and ground plane noise immunity increases. Although deep channels result in a decrease in transconductance, the toggle rate of the Fermi-FET devices with substrate bias will remain about the same as unbiased devices because of the reduced capacitive loading. In a preferred embodiment, the substrate bias is less than 2V in absolute value.

According to another feature of the present invention a drain subdiffusion region may be provided in the semiconductor substrate adjacent the drain, to thereby minimize the effect of both punch through and avalanche breakdown voltages on the device. In particular, the drain subdiffusion is of the same conductivity type as the drain and has a dopant density which is a factor times the dopant density of the substrate. The factor may be selected to simultaneously maximize punch-through breakdown and avalanche breakdown voltages between the drain and substrate. A similar source subdiffusion may also be provided. Immunity to avalanche breakdown and punch-through are thereby both minimized, so that short channel FET devices may operate with full power supply voltage; i.e. a scaled down supply voltage is not needed.

The subdiffusion regions may be employed to improve the performance of conventional FET's, to make them less immune to avalanche and punch-through breakdown. Subdiffusion regions may also be employed to further enhance the performance of the Fermi-FET.

According to yet another feature of the present invention, control of punch-through is further enhanced by ensuring that the depth of the depletion region in the substrate at threshold is the same under the source and drain diffusions as it is under the implemented channel, when zero voltage is applied to the source and drain diffusions. This continuity of depletion boundary at the source and of the channel eliminates punch through cross section and is accomplished by providing substrate enhancement pocket regions into which the drain and source depletion regions are implemented. The substrate pocket regions have the same conductivity type as the substrate and have a doping factor greater than the substrate. The doping factor is chosen to make the depth of the depletion region under the source equal to the depth of the diffusion region under the implemented channel at the threshold voltage.

The Fermi-FET of the present invention particularly lends itself to the use of multiple gate electrodes, for use in complementary MOS (CMOS) or other logic technologies which require connecting of transistors in series to achieve the desired logic function while maintaining essentially zero idle power. When multiple gate Fermi-FET devices are employed, it has been found that performance is improved when the gate immediately adjacent the drain is maintained at a full on value. This gate, referred to as an accelerator electrode, reduces the threshold voltage for the remaining gate or gates in the multi-gate Fermi-FET device.

In order that the present invention may be more readily understood, reference will now be made by way of example to the accompanying drawings, in which:

Figures 1A-1D illustrate cross-sectional views of the Fermi-FET device of the present invention under various operating conditions.

Figures 2A-2D are graphical representations of various device parameters of the present invention, for the operating conditions of Figures 1A-1D.

Figures 3A-3B graphically illustrate gate voltage as a function of carrier density factor according to the present invention.

Figure 4A-4D illustrate cross-sectional views of a process for fabricating Fermi-FET devices according to the present invention.

Figures 5A-5C graphically illustrate drain current versus drain voltage for various values of gate voltage according to the present invention.

Figures 6A-6B graphically illustrate drain current as a function of the channel implant factor for various values of gate voltage according to the present invention.

Figure 7 graphically illustrates junction depletion for Fermi-FET devices of the present invention.

Figure 8 illustrates a cross-sectional view of an FET having source and drain subdiffusion regions according to the present invention.

Figures 9A-9F graphically illustrate maximizing avalanche and punch-through breakdown voltages according to the present invention.

Figures 10A-10D illustrate cross-sectional views of flat-band voltage compensation according to the present invention.

Figures 11A-11B illustrate cross-sectional views of effective channel length of FET's according to the present invention.

Figure 12 graphically illustrates channel penetration into the drain depletion region according to the present invention.

Figure 13 graphically illustrates variation of threshold voltage with distance according to the present invention.

Figure 14 illustrates a cross-sectional view of a Fermi-FET according to the present invention, including an accelerator electrode.

Figures 15A-15B illustrate cross-sectional views of multiple gate Fermi-FET's according to the present invention.

Figures 16A-16B illustrate cross-sectional views of punch-through in conventional FETs.

Figure 17 illustrates a Fermi-FET having continuous depletion boundary according to the present invention.

Figure 18 graphically illustrates the solution of a transcendental equation to obtain the pocket implant factor according to the present invention.

Figure 19 graphically illustrates avalanche breakdown voltage as a function of the pocket implant factor according to the present invention.

Figure 20A-20B graphically illustrate voltage current characteristics of Fermi-FETs according to the present invention.

Figures 21A-21F graphically illustrate drain conductance as a function of drain and gate voltage according to the present invention.

The present invention now will be described more fully hereinafter with reference to the accompanying drawings, in which a preferred embodiment of the invention is shown. For ease of illustration the thickness of layers has been exaggerated. Like numbers refer to like elements throughout. It will be understood by those having skill in the art that the Fermi-FET of the present invention is applicable to both P and N channel devices and to silicon, germanium and other semiconductor materials.

## FET Design Analysis

Before describing the Fermi-FET of the present invention, an analysis of FET design relationships will be developed. Throughout this specification, the terms MOS, FET, MOSFET and IGFET will be employed as synonyms to describe a field effect transistor structure having an insulated gate, wherein the insulation may be, but is not necessarily, an oxide, and wherein the gate may be, but is not necessarily, metal.

An induced channel MOSFET requires a gate voltage to induce an inversion layer of minority carriers that act to conduct current between the source and drain. A gate threshold voltage condition is achieved when the surface potential $\phi_s$ of the semiconductor substrate, below the gate, is elevated sufficiently to bend the intrinsic energy band of the semiconductor material, down below the Fermi level. This rise in substrate surface potential is the result of increasing gate voltage $V_g$ to induce a depletion layer, with depth $W_{do}$, in the substrate below the gate.

Using Poisson's equation, the potential rise across the depletion layer is $\phi_s = (q/2e_s) (N_a W_{do}^2)$, where q is the electron charge in Coulombs, $e_s$ is the dielectric constant of the semiconductor material (Farads/cm), $N_a$ is the substrate acceptor concentration level, and $W_{do}$ is the depletion depth. Depletion depth $W_{do}$, is defined as

$$W_{do} = \sqrt{(2e_s \phi_s/(qN_a))} \ .$$

The electric field at the substrate surface is

$$E_s = \sqrt{(2\phi_s qN_a/e_s)} \ .$$

When the surface potential $\phi_s$ reaches twice the Fermi potential $2\phi_f$, the ionization concentration $N_p$, within a p- substrate, becomes equal to the substrate acceptor concentration $N_a$. Surface potential $\phi_s$ need only be increased slightly above threshold voltage $2\phi_f$ in order to achieve inversion.

Unfortunately, charge is accumulated on the gate as a result of creating the inversion layer. The density of this gate charge is $qN_a W_{do}$ Coulombs per cm$^2$. Gate threshold voltage $V_t$ is the sum of the voltage developed across the gate oxide layer and the rise in substrate potential $2\phi_f$. The gate oxide field is $qN_a W_{do}/e_i$ and the voltage $V_{ox}$ is $qN_a W_{do}/C_i$ where $C_i = e_i/T_{ox}$ and $T_{ox}$ is the oxide thickness. Therefore,

$$V_t = \frac{L^*}{L} \frac{\sqrt{2e_s qN_a \phi_s}}{C_i} + \phi_s - V_{cs} + V_{cg} \tag{1}$$

Where;

$\phi_s = 2\phi_f$ ,
$L^*$ = Effective channel length, as described in detail below,
$V_{cs}$ = substrate contact potential, and
$V_{cg}$ = gate contact potential.

When voltage is applied to the drain and source regions, a potential V(X) is introduced at position X along the channel between the drain and source. This potential is described in detail below. The oxide threshold voltage term in Equation 1 increases with voltage V(X) in accordance with Equation 2:

$$V_t(X) = \frac{L^*}{L} \frac{\sqrt{2e_s qNa\,\phi_s\left(1+\dfrac{V(X)}{V_0}\right)}}{C_i} + \phi_s\left(1+\frac{V(X)}{V_0}\right) - V_{cs} + V_{cg} \tag{2}$$

Thus, the threshold voltage contribution due to gate charge Equation 2 is complex and causes difficulties in both digital and analog circuit design and device fabrication. In particular, high speed short channel C-MOS logic design is severely compromised by this threshold voltage term. Threshold voltage sensitivity to substrate surface doping also hinders corrective measures needed to eliminate drain-source punch-through in conventional short channel MOSFET devices.

## The Fermi - FET Concept

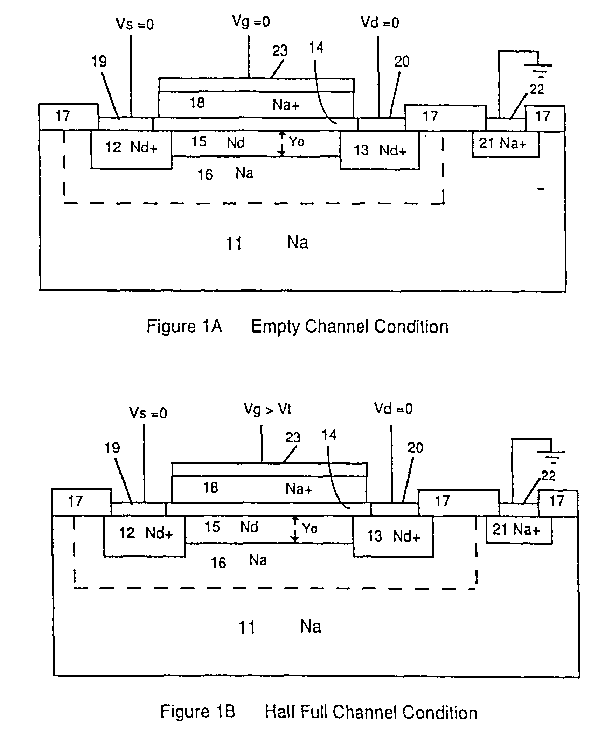

According to the present invention Fermi-FET design is achieved by a grounded source FET device devoid of the complex threshold voltage term shown in Equation 1 above. The basic N-Channel Fermi-FET is illustrated by Figure 1A. A P-channel Fermi-FET is fabricated the same way but with opposite conductivity materials.

Referring now to Figure 1A a Fermi-FET 10 according to the present invention is fabricated in a semiconductor substrate 11 having an acceptor concentration $N_a$. It will be understood by those having skill in the art that semiconductor substrate 11 may be silicon, gallium arsenide or other semiconductors, and may be an epitaxial or "tub" region formed in a semiconductor substrate. Source region 12 and drain region 13 are formed in the semiconductor substrate. Source and drain regions 12 and 13 are of opposite conductivity from substrate region 11 and have a higher donor concentration (i.e. they are doped $N_d^+$). Source electrode 19 and drain electrode 20 form external contacts for these regions. A thin gate oxide layer 14 is formed on the surface of substrate 11. A gate contact is formed on the gate oxide 14. In the embodiment illustrated gate contact comprises a polysilicon gate contact 18 and a metal gate electrode 23 for reasons described more fully below. A substrate contact region 21 is formed within the semiconductor substrate 11. Contact **21** is typically of the same conductivity as substrate **11** but more highly doped (e.g. it is doped $N_a^+$). Finally, field oxide regions **17** isolate devices from one another.

According to the present invention a channel **15** having the same conductivity type as the source and drain regions and opposite conductivity to the substrate is formed for example by implanting through thin gate oxide layer **14**. The channel has a depth $Y_0$ and a donor doping level $N_d$. The depth and doping and channel are critical for forming the Fermi-FET device of the present invention. In one embodiment, the substrate is a P-type substrate while source drain and channel regions are N-type.

It will be shown according to the present invention that when channel **15** has the proper doping level and depth that a depletion region **16** is formed in substrate **11** and the channel **15** is completely self-depleted as shown in Figure 1A.

Still referring to Figure 1A, the basic criteria for an N-channel Fermi-FET will now be described. The criteria for P-channel devices are the same except donor and acceptor ion types are interchanged. The nominal implant depth $Y_0$ of the channel is governed by Equation 3A and the effective donor concentration $N_d^*$ is defined by Equation 3C.

$$Y_0 = \sqrt{\frac{2e_s V_0}{qNd^*}\left(\frac{Na}{Na+Nd^*}\right)} = \sqrt{\frac{2 e_s \phi_s}{q N_s \alpha (\alpha+1)}} \qquad (3A)$$

$$V_0 = \phi_s = 2\phi_f + \frac{KT}{q}\ln\left(\frac{N_d^*}{N_a}\right) \qquad (3B)$$

$$N_d^* = \frac{1}{d}\int_0^d N_d(y)\,dy = \alpha N_s \qquad (3C)$$

Given proper dose and depth, the implanted channel **15** is completely self-depleted as shown in Figure 1A. Complete channel self-depletion is the result of electron and hole diffusion across the junction between the channel **15** and the substrate **11**. This carrier diffusion process is required to establish a constant Fermi potential across that P-N junction region. There are critical conditions for the implant depth and dose. The entire implanted channel with depth $Y_0$, (Equation 3A), must be depleted of mobile electrons when the electric field $E_o$ at the channel-substrate junction reaches the value needed to terminate carrier diffusion across that junction. The total voltage $V_0$ developed across the depleted substrate **16** and channel region 15 (Equation 3B) raises the substrate surface potential $\phi_s$ to twice the Fermi potential $2\phi_f$, if and only if $N_d^* = N_a$. In general, $N_s$ defines the substrate doping density and $N_c$, the channel doping density. This threshold voltage condition $2\phi_f$ is achieved without introducing charge on the gate. This condition is true since the normal component of electric field, due to depletion effects, is zero at the surface of the semiconductor below the gate.

The total threshold voltage expression for the Fermi-FET is therefore;

$$V_t = \phi_s \left\{ \frac{\alpha}{\alpha+1}\left(1+\frac{V_s}{\phi_s}\right) + \frac{2}{\alpha+1}\sqrt{1+\frac{V_s}{\phi_s}} - \frac{1}{\alpha+1}\right\} + \frac{1}{C_i}\sqrt{2 q N_s e_s\left(\frac{\alpha}{\alpha+1}\right)\phi_s}\left[\sqrt{1+\frac{V_s}{\phi_s}} - 1\right]$$

$$(4)$$

Where

$V_s$ = Source voltage,
$\phi_s = 2\phi_f + \frac{KT}{q}\ln(\alpha)$, and
$\alpha = N_d^*/Na$

Given the special condition $N_d^* = N_a$, i.e. $\alpha=1$, the correct implant depth (Equation 3A) becomes

$$Y_0 = \sqrt{\frac{2\phi_f e_s}{qN_a}} \qquad (5)$$

Where:

$$\phi_f \;=\; \frac{KT}{q} \; \ln\!\left(\frac{N_a}{N_i}\right) \;\;,$$

$e_s =$     dielectric constant of silicon,

$N_s =$     Acceptor concentration of substrate (N-channel), and

$N_i =$     Intrinsic carrier concentration.

Table 1 lists nominal values for implant depth $Y_0$ in silicon as a function of substrate doping for $\alpha=1$. The correct implant depth is subject to the condition $N_d^* = N_{as}$ for an N-channel device or $N_a^* = N_{ds}$ for a P-channel device. Subscript s denotes substrate.

TABLE 1

| $N_{as}$ or $N_{ds}$ (cm$^{-3}$) | Critical Implant Depth, $Y_0$ (Angstroms) |
|---|---|
| $1\times10^{17}$ | 714 |
| $5\times10^{16}$ | 988 |
| $2\times10^{16}$ | 1523 |
| $1\times10^{16}$ | 2087 |
| $8\times10^{15}$ | 2314 |
| $5\times10^{15}$ | 2875 |
| $1\times10^{15}$ | 6008 |

The Fermi-FET design of the present invention achieves the objective of eliminating the complex oxide threshold voltage first term (Equation 1) typical of conventional enhancement MOSFET's. It will be shown subsequently that fabrication of the Fermi-FET is relatively simple and is applicable to long, medium, and short P- and N-channel devices. The benefits of the Fermi-FET are: high manufacturing yield,'high speed circuit capabilities (low giga-hertz range), control of punch-through and avalanche breakdown, minimization of hot electron effects, and greatly simplified user design groundrules for both analog and digital circuits.

### Fermi - FET Operation

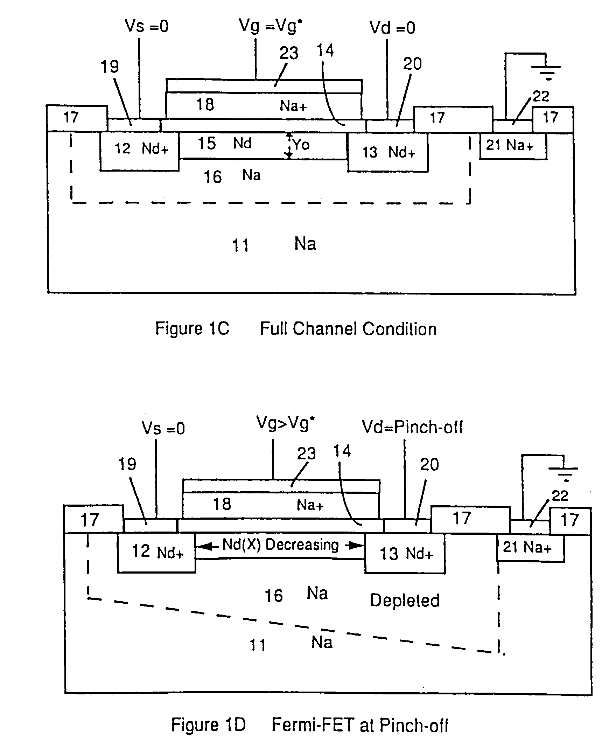

Referring again to Figures 1A through Fig 1C, as gate voltage $V_g$ is increased above threshold voltage $V_t$, electric field and potential increase at the substrate surface directly below the gate. This rise in surface electric field and potential occurs as mobile electrons fill the holes in the depleted implant channel region **15**. The holes in the depleted channel **15** are uniformly filled as gate voltage is increased above threshold. The half full and full channel conditions are illustrated by Figures 1B and Figure 1C respectively. For each hole filled in the depleted channel **15**, a unit of positive charge ($1.6\times10^{-19}$ Coulombs) appears on the gate electrode in order to conserve charge. Filling the empty donor sites of the implanted channel with electrons allows conduction current to flow between the source and drain. The channel is totally charge neutral when all of the empty holes are filled with electrons. When charge neutrality occurs, the volume density of conduction carriers corresponds to the donor concentration $N_d$. Increasing gate voltage to induce the full channel value, $V_g^*$, fills the entire depleted channel region with electrons.

The full channel condition is illustrated by Fig. 1C. When "full" channel conditions are achieved, positive charge density on the gate electrode is uniform and has the value $qN_aY_o$ Coulombs/cm$^2$ for $\alpha=1$. The electric field developed across the oxide layer is, $E_{ox} = (qN_aY_o)/e_i$ and the electric field at the surface of the semiconductor and across the "full" implanted region is $(qN_aY_o)/e_s$ since $\nabla\cdot D = 0$ there and in the oxide layer. The oxide potential is $V_{ox} = (qN_aY_oT_{ox})/e_i$. Gate voltage $V_g^*$, at "full" channel conditions, is the sum of the oxide potential $V_{ox}$ and potential $\phi_s$ developed across the channel **15** and the ionized region of the substrate below the channel.

Referring now to Figure 1D, when gate voltage $V_g$ exceeds the "full" channel value $V_g^*$, excess charge (mobile carriers) becomes available in the implanted channel region **15**. These excess carriers account for the increase in channel current in proportion to gate over-drive voltage, $V_g > V_g^*$. A unit of positive charge also appears on the gate electrode for each excess electron created in the channel.

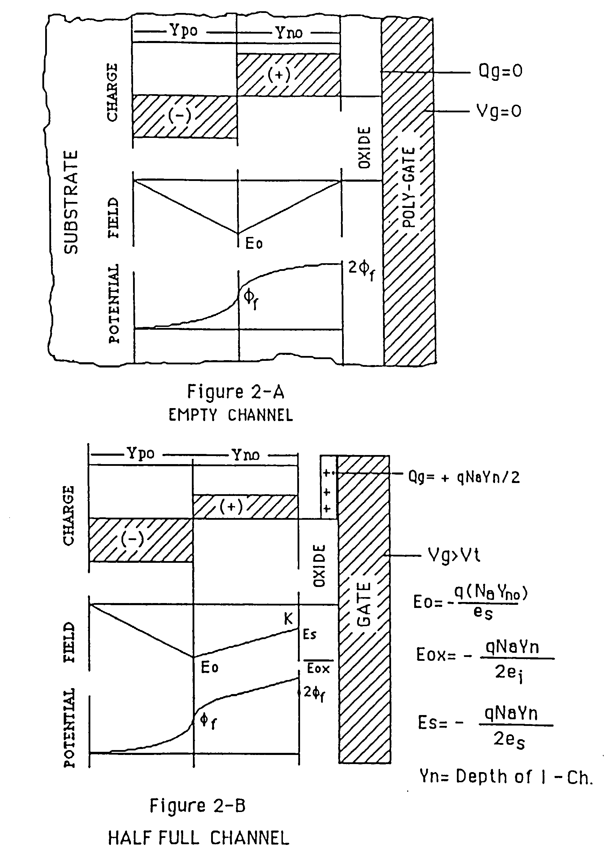

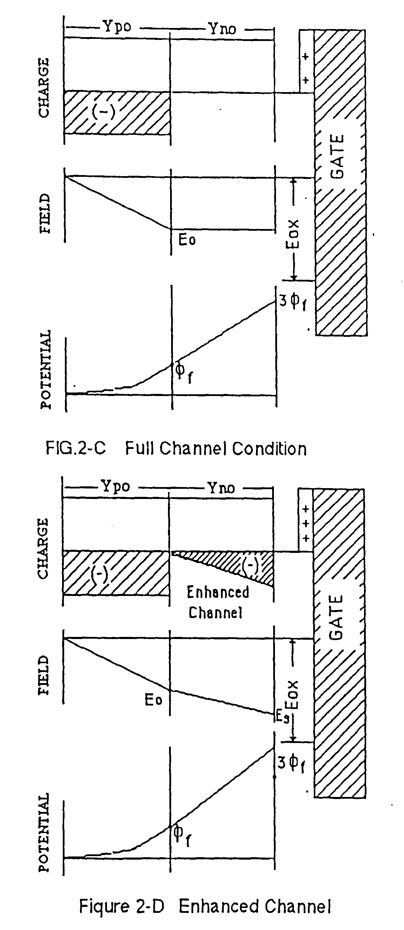

Figures 2A-2D illustrate the charge distribution, electric field, and potential for the "empty", "half-full", "full", and "enhanced" channel conditions illustrated in Figures 1A-1D respectively, for the case $N_d^* = N_a$. These conditions depend on gate voltage $V_g$.

Referring to the "full" channel condition, (Figure 2C) gate to substrate voltage $V_g^*$, is given by:

$$V_g^* = V_{ox} + V_{ch} + V_j \tag{6}$$

Where in general:

$$V_{ox} = \frac{qN_d^* Y_o}{C_i} \text{ Voltage Across Oxide Layer} \tag{7A}$$

$$E_i = \frac{qN_d^* Y_o}{\varepsilon_i} \text{ Electric Field Across Gate Insulator} \tag{7B}$$

$$V_{ch} = E_{yo} Y_o = \frac{qN_d^* Y_o^2}{e_s} \text{ Voltage Across Channel} \tag{7C}$$

$$E_{yo} = \frac{qN_d^* Y_o}{e_s} \text{ Field Across Channel} \tag{7D}$$

$$V_j = \phi_s \frac{N_d^*}{N_d^* + N_a} \text{ Voltage At Substrate- Channel Junction} \tag{7E}$$

$$\phi_s = \frac{KT}{q} \ln\left(\frac{N_a N_d^*}{N_i^2}\right) \tag{7F}$$

$$Y_{no} = \sqrt{\frac{2e_s \phi_s}{qN_d^*}\left(\frac{N_a}{N_a + N_d^*}\right)} = \sqrt{\frac{2 e_s \phi_s}{q N_a \alpha (\alpha+1)}} \tag{7G}$$

$$Y_{po} = \sqrt{\frac{2e_s \phi_s}{qN_a}\left(\frac{N_d^*}{N_a + N_d^*}\right)} \tag{7H}$$

$$N_d^* = \frac{1}{d} \int_o^d N_d(Y)\ dY = \alpha N_a \tag{7I}$$

For the special case, $N_d^* = N_a$, the following relations apply:

$$V_{ox} = \frac{qN_a Y_o}{C_i} \tag{8A}$$

$$V_{ch} = EY_o = 2\phi_f \tag{8B}$$

$$E_{yo} = \frac{qN_a Y_o}{e_s} \tag{8C}$$

$$V_j = \phi_f \tag{8D}$$

$$\phi_s = 2\phi_f \tag{8E}$$

$$Y_{no} = Y_o \tag{8F}$$

$$Y_{po} = Y_o \tag{8G}$$

$$Y_0 = \sqrt{\frac{2\phi_f e_s}{qN_a}} \tag{8H}$$

Substituting the appropriate Equation 8A-8H into Equation 6, the following relationship is obtained:

$$V_g^* = \frac{1}{C_i}\sqrt{2\phi_f e_s q N_a} + 2\phi_f + \phi_f \tag{9}$$

Accordingly, for the depleted (empty) channel conditions, (Figure 2A), the potential rise $\phi_s$ at the first semiconductor surface, under the gate, is $\phi_s = 2\phi_f$ volts given $N_d^* = N_a$ and no source voltage. Therefore the potential applied to the gate electrode must exceed the surface potential ($\phi_s = 2\phi_f$) in order to start filling the depleted channel with conduction electrons. The gate threshold voltage is $\phi_s$ in general (Equation 7F) and $2\phi_f$ in particular when $N_d^* = N_a$. This is a very simple criterion for threshold voltage when compared to the threshold criteria for a conventional MOSFET. The nominal grounded source Fermi-FET configuration completely eliminates the oxide voltage term (Equation 10) characteristic of conventional MOS device threshold voltage. (Note that the origin of L* will be described in detail below):

$$V_t = \frac{L^*}{L}\frac{\sqrt{2e_s q N_a \phi_s}}{C_i} \tag{10}$$

The nominal Fermi-FET has a threshold voltage expression given by Equation 4 that includes effects of source voltage $V_s$. Elimination of the conventional MOSFET oxide threshold voltage component significantly enhances Fermi-FET performance. This is a result of eliminating threshold voltage dependance on channel length, oxide thickness, drain voltage, and the doping level of the semiconductor surface.

One method of preventing punch-through in short channel devices is to simply increase substrate doping. Threshold voltage for the Fermi-FET does not include the the complex term Equation 10 and therefore low threshold voltage can be maintained virtually independent of substrate doping. Substrate doping affects threshold voltage in the Fermi-FET only slightly due to the logarithmic dependence of the Fermi potential term $\phi_f$. A method for further enhancing the resistance to punch-through will be described below.

Referring to Equation 9, the net gate voltage $V_g^* - V_t$ required to fill the I-channel with conduction electrons may be obtained. Since threshold voltage is $2\phi_f$, it follows that:

$$V_g^*\text{-}V_t = \frac{\sqrt{2e_s q N_a \phi_f}}{C_i} + \phi_f \tag{11}$$

When drain voltage $V_d$ is increased, (source at ground potential), a critical drain ("pinch-off") saturation condition is attained (described in detail below) for a given gate voltage $V_g$. Carrier concentration within the conduction channel diminishes to a minimum value at the drain. When "pinch-off" is achieved, drain current saturates. The saturation condition is illustrated by Figure 1D.

The effects in the channel when gate voltage $V_g$ exceeds the "full" channel value $V_g^*$ will now be described. This analysis assumes an N-channel Fermi-FET device with source and substrate voltage at ground potential. When gate voltage $V_g > V_g^*$, channel conduction capability is enhanced by increasing the volume density of conduction electrons $N_p^*$ in the channel 15 above the donor value $N_d^* = N_a$. See Figure 2D. Gate oxide potential $V_{ox}$ is proportional to the total channel charge $q N_p^* Y_o$ where $N_p^*$ is the total volume concentration of conduction carriers in the enhanced channel. Since the implanted channel is N-type, the Fermi level is already close to the conduction band. The conduction energy band need not be bent down very far to increase the number of conduction carriers in the implanted channel region. The increase in surface potential $\phi_s$ needed to realize a carrier concentration $N_p^*$ greater than $N_a$ is $\phi_s = KT/q \ln(N_p^*/N_a)$. An increase in surface potential of 18 mv is required for the case where $N_p^* = 2N_a$.

In view of the Fermi-FET structure, it follows that most of the enhanced carrier concentration ($N_p^* - N_a$) will be confined to a maximum depth prescribed by depth $Y_o$ of the implanted channel, because the ionized P-substrate region 16, located below the channel implant region 15, has a maximum potential $\phi_f$ at the junction between the implanted channel and the substrate when $N_d^* = N_a$. The remote location of the ionized substrate region from the surface and the junction potential $\phi_f$ results in a carrier concentration near the intrinsic value $N_i = 1.5 \times 10^{10}$ cm$^{-3}$ for silicon. Thus a majority of the gate enhanced excess carrier concentration ($N_p^* - N_a$) is located below the surface of the substrate and resides within the critical implant depth $Y_0$. If gate voltage $V_g$ is less than $V_g^*$, the implanted channel is only partially filled, a factor $F \leq 1$ applies. For enhanced channel conditions, $F > 1$. For the general condition $0 < F$:

$$V_g = F\frac{\sqrt{2e_s q N_a \phi_f}}{C_1} + \phi_f(2+F) \tag{12}$$

where

$$F = N_p^*/N_a \, ,$$

$$V_{ox} = \frac{1}{C_1} \sqrt{2\phi_f e_s qFN_a} \, ,$$

$V_{ch} = \phi_f(1+F)$, and
$V_j = \phi_f.$

From Equation 12 it may be seen that $V_g = V_t = 2\phi_f$ when the channel filling factor $F = N_p^*/N_a = 0$. Evaluating Equation 12 for the full channel condition, $F = 1$, under the following conditions.

$Na =$    $5X10^{16}$ cm$^{-3}$
$\phi_f =$    .39 volts
$e_s =$    $1X10^{-12}$ Farads/cm
$q =$    $1.6X10^{-19}$ Coulombs
$C_i =$    $1.5X10^{-7}$ Farads/cm$^2$
$Y_0 =$    $9.87X10^{-6}$ cm
$F =$    1.0

the following results are obtained:

$V_g^* = 1.69$ Volts $= 4.34\phi_f$
$V_g^* - V_t = .916$ Volts $= 2.43\phi_f$
$V_t = 2\phi_f .78$ Volts

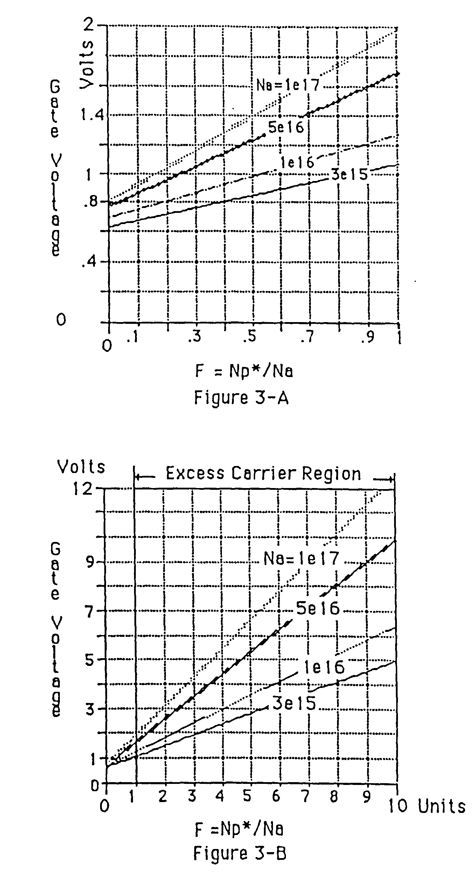

Figure 3A is a plot of Equation 12 as a function $0 \le F \le 1$ for different values for acceptor concentration $N_a$. Figure 3B is a plot of gate voltage $V_g$ as a function of F in the range $0 \le F \le 10$ and different substrate acceptor concentration $N_a$. When $F > 1$, excess carriers exist in the implanted channel and account for increased channel current. The linear behavior of $V_g$ with $F > 1$ should be noted. This linear relationship is a distinct and useful advantage of the Fermi-FET.

Equations 13A - 13D present a comparison of threshold voltage for a conventional MOSFET with the ideal Fermi-FET and the deep and shallow versions resulting from errors introduced during channel implant.

$$V_{t^-} = 2\phi_f + \frac{\sqrt{2}}{C_1} \sqrt{2e_s qN_a \phi_f} \text{ Standard MOSFET} \tag{13A}$$

$$V_t = 2\phi_f \text{ Nominal Fermi-FET} \tag{13B}$$

$$V_t = 2\phi_f + \frac{F\sqrt{2}}{C_1} \sqrt{2e_s qN_a \phi_f} \text{ Shallow Fermi-FET } Y = Y_o(1-F) \tag{13C}$$

$$V_{t+} = 2\phi_f - \left( \frac{F}{C_1} \sqrt{2e_s qN_a \phi_f} + \phi_f F^2 \right) \text{ Deep Fermi-FET} \tag{13D}$$
$$Y = Y_o(1+F)$$

## Method of Fabricating the Fermi-FET

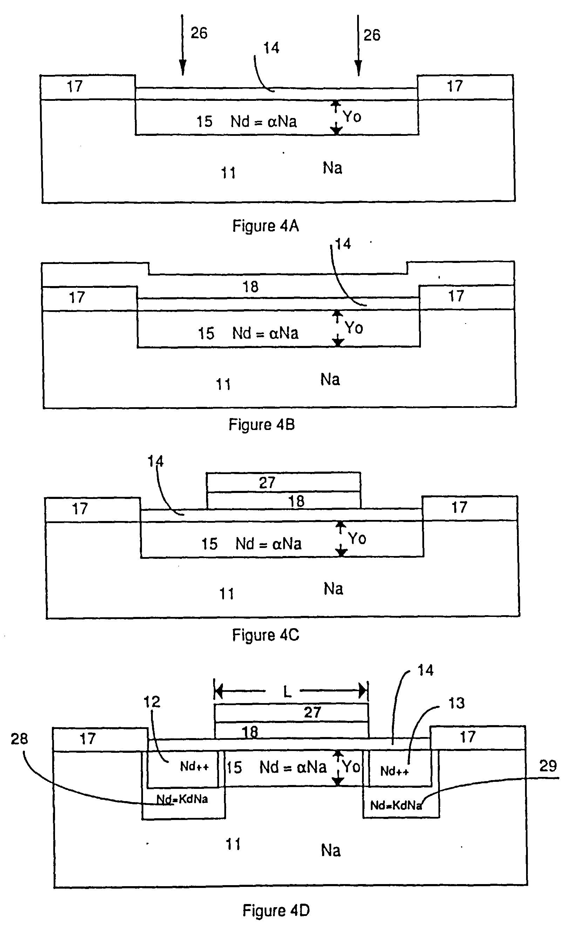

Referring now to Figure 4, a method of fabricating a Fermi-FET according to the present invention will now be described. In the method illustrated herein, a P-type polysilicon gate is provided for an N-channel Fermi-FET. Conversely, an N-type polysilicon gate is provided for a P-channel Fermi-FET. As described in detail below metal-semiconductor contact potentials may significantly influence threshold voltage of any FET including the Fermi-FET. To avoid this extraneous variation in threshold voltage, a polysilicon gate is provided.

Referring now to Figure 4A. A portion of p-substrate region **11** having acceptor concentration $N_a$ is illustrated. This substrate region may be formed by implanting and driving in a dopant in an unmasked area of an intrinsic **4**μ silicon epitaxial layer grown on a silicon, sapphire or other substrate. Thick and thin oxide layers **17** and **14** respectively are also shown. All P-channel devices are covered with photo-resist material (not shown) while low energy N-type ions (phosphorous or arsenic for example) are implanted in the direction shown by arrows **26** through the thin oxide layer **14**, into the surface of the P-doped substrate. This implant provides an N-type channel region **15** with proper depth $Y_0$. The implant dose must also be controlled such that the average doping value achieves the condition; $N_d^* = \alpha N_a$, where $N_d^*$ is defined by Equation 3C. P-channel implant follows similar procedures except opposite ions are implanted. This implant step is critical for both the P- and N-channel devices. Care must be exercised to achieve the proper implant energy and dose.

Referring to Figure 4B, after appropriate masking and implanting both P- and N-channels **15** through the thin oxide region **14**, all photoresist material is removed and intrinsic polysilicon **18** is deposited over the entire surface of the wafer.

It will be understood that the wafer may contain both P- and N-channel areas. While these figures show only N-channel areas, the P-channel areas may be formed as follows: Regions of the wafer containing intended P-channel devices, for example, may be masked with photoresist material leaving polysilicon exposed that overlays the N-channel devices. P-type ions (e.g. Boron) may then be implanted into the exposed polysilicon layer converting intrinsic polysilicon to P$^{++}$ type. Then the photoresist masking material, covering the P-channel devices, may be removed and a new masking layer of photoresist material may be deposited over all N-channel devices. N-type ions are then implanted into the exposed polysilicon overlaying the P-channel devices, converting those polysilicon regions to N$^{++}$ type. The energy of both doping implants must be low enough for the given thickness of the polysilicon layer, not to penetrate the full depth of that layer. The next step in the process is to remove the photoresist material. This step is then followed by covering the entire exposed polysilicon surface with photoresist material. The depth must be thick enough to block subsequent implantation from penetrating non-etched regions of this barrier layer.

Referring now to Figure 4C, a self-aligned poly gate mask **27** is applied next. This gate mask is aligned to lie in the center region of the implanted P- and N-channel devices, and provides the definition for the polysilicon gate. Next all of the exposed barrier and polysilicon layers are etched away leaving the appropriately doped polysilicon gate region with an overlaying photoresist layer as shown in Figure 4C.

Referring now to Figure 4D, photoresist material is then applied to mask the P-channel devices while drain and source contact regions **12** and **13** respectively and optional field reducing regions **28** and **29** are implanted in the N-channel devices. The functions of field reducing regions **28** and **29** will be described below. Then this photoresist material is removed from the P-channel devices and new material applied over the N-channel devices. The P-type source and drain regions of the P-channel devices are then implanted. The photoresist used to mask the N-channel devices is then removed and the source and drain regions of the P-channel devices are formed. An oxidation step may then form oxide on the side-walls of the polysilicon gates previously defined and to anneal the implants. This oxidation also thickens the oxide layer over the source and drain regions. The remaining steps in the process need not be described here since they comprise well known and conventional steps for fabricating FET devices. These process steps include removal of oxide over the source, drain, gate, and substrate contact regions, and the application of surface pasivation and contact metal to these exposed regions.

An alternative method of fabricating Fermi-FETs according to the invention, using *in-situ* poly-gate doping will now be decribed. According to this method, after appropriate masking and implanting both P- and N-channels through the thin oxide region, all photoresist material is removed and *in-situ* P$^+$ doped polysilicon layer is deposited over the entire surface of the wafer as shown in Figure 4B. The dopant density of the P$^+$ polysilicon should be high enough to permit Ohmic-metal contact to its surface. P-channel areas may be formed in these same processes as follows. Regions of the wafer containing intended N-channel devices are masked with photo-resist material leaving polysilicon exposed that overlays the P-channel devices. N-type ions such as phosphorous or arsenic are then implanted into the exposed polysilicon layer converting the *in-situ* doped P$^+$ poly-silicon to N$^+$ type. The dopant density of the N-polysilicon should be high enough to permit Ohmic-metal contact to its surface.

Then the photo-resist masking material, covering the N-channel devices, is removed. The energy of the doping implant must be low enough for the given thickness of the polysilicon layer, not to penetrate the full depth of that layer. A subsequent anneal activates and homogenizes this implant concentration. The next step in the process is to remove the photo-resist material. This step is then followed by covering the entire exposed polysilicon surface with photoresist material. The depth of this barrier must be thick enough to block subsequent implantation from penetrating non-etched regions. The self-aligning poly gate mask is applied next. The remaining steps are the same as previously described.

## Fermi-FET Channel Doping Considerations

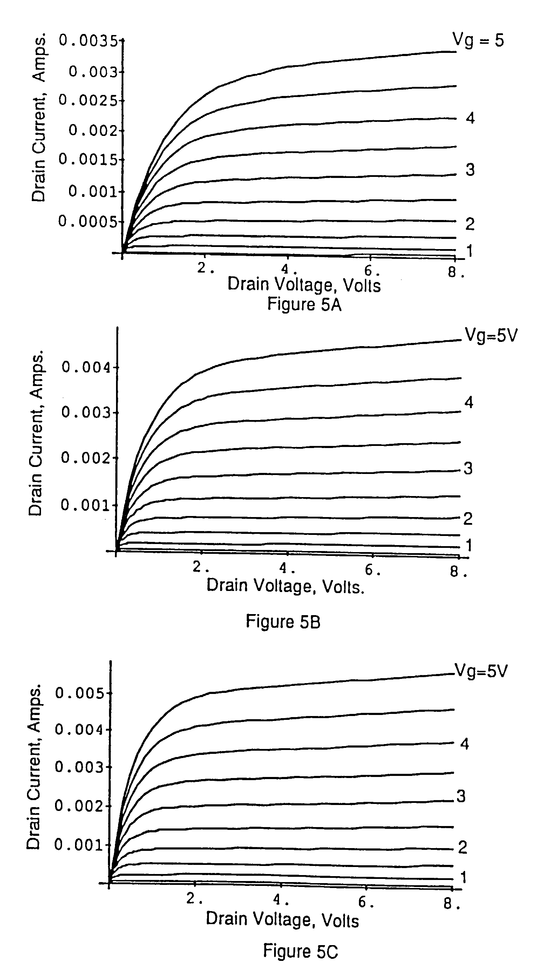

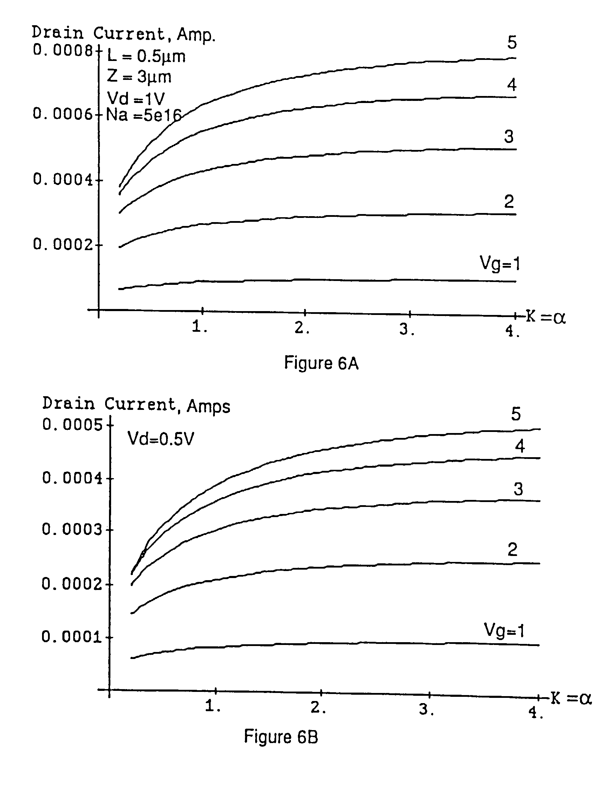

The effects of channel implant concentration $N_c = \alpha N_s$ has a significant effect on drain current properties of the Fermi-FET device. Pinch-off voltage has already been described for the special case where $\alpha=1$. This restricted the implant concentration (Equation 3C) to equal the substrate concentration with a critical depth characteristic of that condition. Below, the general expression for pinch-off Voltage $V_p$ for $\alpha$ in the range $1 > \alpha > 1$ is provided (Figure 6). Computer plots of n-channel devices are also presented for $N_a = 1e^{17}$ and $\alpha = 0.2$, 1.0, and 5.0 (Figure 5). Referring to these figures, it will be seen that Fermi-FET devices with low pinch-off voltage are attained when $\alpha > 1$. A preferred

value is $\alpha=2$. This value for $\alpha$ leads to high transconductance and low saturation drain conductance for sub-micron channel length devices.

The general expression for pinch-off voltage is as follows:

$$V_p = \frac{V_g - V_t}{\eta}\left(1-\frac{1}{M^{\frac{1}{3}}}\right) + \frac{2K_1}{\eta}\left(1+\frac{K_1}{\eta\,\phi_s}\right) - \frac{2K_1}{\eta^2\,\phi_s}\sqrt{\eta\,\phi_s\,(V_g - V_t)\left(1-\frac{1}{M^{\frac{1}{3}}}\right) + (K_1 + \eta\,\phi_s)^2}$$

$$(14)$$

where

$$\eta = \frac{\alpha}{\alpha+1}$$

$$\phi_s = 2\phi_f + \frac{KT}{q}\,Ln\,\alpha$$

$$A = A_1 = \frac{1}{C_i}\sqrt{2\,q\,N_s\,\phi_s\left(\frac{\alpha}{\alpha+1}\right)e_s}$$

$$K_1 = \frac{A}{2} + \frac{\phi_s}{\alpha+1}$$

$$M = \left(\frac{\mu_0\,E_i}{V_{sat}}\right)^{3/2}$$

$$V_t = \phi_s$$

Referring now to Figure 5A, a plot of gate voltage as a function of drain current and drain voltage for channel length of 1$\mu$m, $\mu_o = 750$, $N_a = 1\times10^{17}$, $T_{ox} = 200$Å, and $\alpha = 0.2$ is provided. Gate voltage is shown in steps of 0.5V, starting at OV. Figure 5B presents the same series of plots under the same conditions except that $\alpha=1.0$. Figure 5C presents the same series of plots for $\alpha=5.0$.

The computer generated plots of Figure 6 illustrate the influence of channel implant factor $\alpha$ on the rising current (low drain voltage) property of the Fermi-FET device. Figure 6A illustrates drain current as a function of channel implant factor $\alpha$ with $V_d=1V$, $L=0.5\mu$, $Z=3\mu$ and 1 Volt per step for gate voltage, $N_a=5\times10^{16}$, $\mu_{oo}=1200$, $E_i=2.5\times10^5$V/cm.

Figure 6B shows drain current as a function of channel implant factor $\alpha$ with $V_d=.5V$, $L=0.5\mu$, $Z=3\mu$, 1 Volt per step for gate voltage, $N_a=5\times10^{16}$, $\mu_{oo}=1200$, $E_i=2.5\times10^5$V/cm. It is apparent that most of the change occurs when $\alpha=N_c/N_s$ < 2. i.e., Drain resistance decreases with increasing $\alpha$. $N_c$ is the implanted channel impurity concentration and $N_s$ represents the substrate impurity concentration, Ions/cm$^3$. Accordingly, in designing Fermi-FET devices, one should strive to use a channel implant factor $\alpha$ of about 2.0.

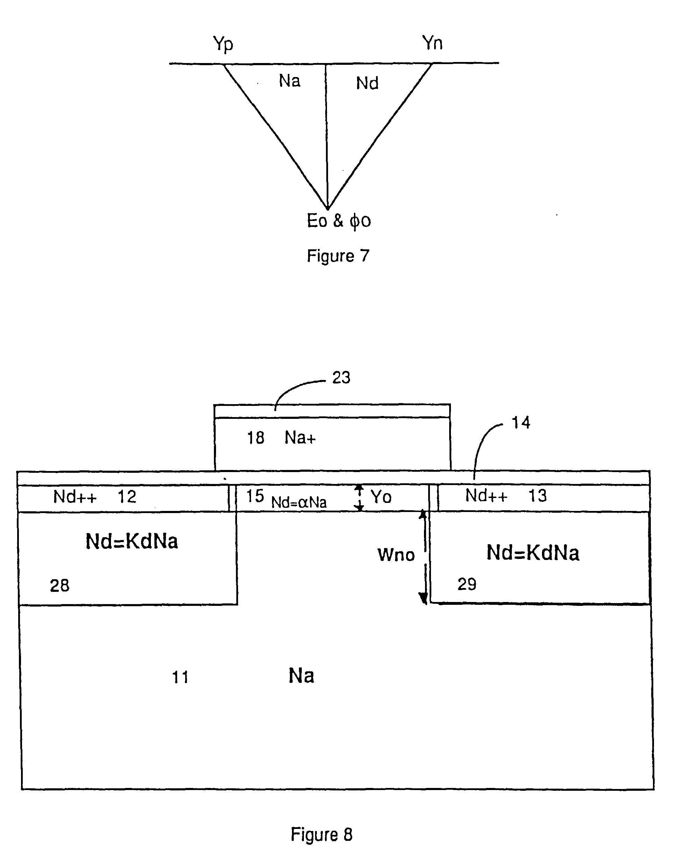

Figure 7 illustrates the junction between the implanted channel **15** and the substrate **11** of Figure 1A. The peak electric field $E_0$ and potential $\phi_0$ are shown at the stochastic junction between the implant and the substrate. The depletion depth developed in the substrate is $Y_p$ and the depleted implant depth is defined as $Y_n$. Since

$$E_0 = \frac{qN_a}{e_s}\,Y_p \quad \text{and} \tag{15}$$

$$\phi_0 = \frac{qN_a}{2e_s}\,Y_p{}^2\,, \tag{16}$$

therefore

$$Y_p = \sqrt{\frac{2e_s}{qN_a}\,\phi_0}\,. \tag{17}$$

$\phi_o$ may be expressed In terms of surface potential $\phi_s$. From Figure 7 the following is obtained:

$$\phi_s = \phi_o + \frac{1}{2}\,Y_n E_o \tag{18}$$

Substituting for $E_0$:

$$\phi_s = \phi_0 + \frac{1}{2} Y_n \frac{N_a}{N_d} \left( \frac{qN_a}{e_s} \right) Y_p \qquad (19)$$

Based on the definition of $\phi_o$ the following is obtained:

$$\phi_0 = \phi_s \frac{N_d}{N_d + N_a} \text{ and} \qquad (20)$$

$$Y_p = \sqrt{\frac{2e_s}{qN_a} \left( \frac{N_d}{N_d + N_a} \right) \phi_s} \qquad (21)$$

Similarly

$$Y_n = \sqrt{\frac{2e_s}{qN_d} \left( \frac{N_a}{N_d + N_a} \right) \phi_s} \qquad (22)$$

Now, if the implant concentration varies in depth $N_d(Y)$, then:

$$E(y) = -\frac{q}{e_s} \int_0^Y N(y)\, dy \ , \ \text{ and} \qquad (23)$$

$$\phi_0 = \frac{q}{e_s} \int_0^{Y_n} dy \int_0^{Y_n} N(y)\, dy \ \cdot \qquad (24)$$

Multiplying Equation 24 top and bottom by $Y_n$

$$\phi_0 = \frac{q}{e_s} \int_0^{Y_n} Y_n\, dy \ \frac{1}{Y_n} \int_0^{Y_n} N(y)\, dy \qquad (25)$$

The last integral in Equation 25 represents an average value. Thus,

$$\phi_0 = \frac{q}{2e_s} Y_n^2 N_d^* \qquad (26)$$

$$Y_n = \sqrt{\frac{2e_s}{qN_d^*} \phi_0} \qquad (27)$$

Accordingly, the necessary conditions for the channel implant at depth $Y_n$ are;

$$\frac{1}{Y_n} \int_0^{Y_n} N_d(y)\, dy = N_d^* = \alpha N_a \qquad (28)$$

After an anneal process depth spreading may be expected, so that

$$\frac{1}{Y_n'} \int_0^{Y_n'} N_d(y)\, dy = N_d^{*\,'} \qquad (29)$$

The integrals of Equations 28 and 29 must be the same since charge is conserved. Therefore,

$$Y_n N_a = Y'_n N_d^{*'} \tag{30}$$

$$Y'_n = \frac{N_a}{N_d^{*'}} Y_n \tag{31A}$$

$$N_d^{*'} = \frac{Y_n}{Y'_n} N_a \tag{31B}$$

The depth of the depletion region in the substrate, $Y_p$ remains the same, before and after the anneal, since the total implant charge is unaltered.

$$q \int_0^{Y_s} N(y)dy = q \int_0^{Y'} N'(y)dy \tag{32}$$

Tables 2 and 3 illustrate values of implant channel depth $Y_0$ in cm for various values of $\alpha$ and $N_a$.

TABLE 2

| $\alpha = N_c/N_s$ | $Y_o @ N_a = 1 \times 10^{16}$ | $Y_o @ N_a = 1 \times 10^{17}$ |
|---|---|---|
| 1.0000000 | 2.0876457e-05 | 7.1460513e-06 |
| 1.2500000 | 1.7677658e-05 | 6.0474366e-06 |
| 1.5000000 | 1.5360821e-05 | 5.2522975e-06 |
| 1.7500000 | 1.3597864e-05 | 4.6475990e-06 |
| 2.0000000 | 1.2207786e-05 | 4.1710276e-06 |
| 2.2500000 | 1.1081721e-05 | 3.7851283e-06 |
| 2.5000000 | 1.0149919e-05 | 3.4659164e-06 |
| 2.7500000 | 9.3654684e-06 | 3.1972686e-06 |
| 3.0000000 | 8.6955825e-06 | 2.9679200e-06 |
| 3.2500000 | 8.1166127e-06 | 2.7697490e-06 |
| 3.5000000 | 7.6110519e-06 | 2.5967449e-06 |
| 3.7500000 | 7.1656491e-06 | 2.4443597e-06 |
| 4.0000000 | 6.7701829e-06 | 2.3090859e-06 |
| 4.2500000 | 6.4166374e-06 | 2.1881738e-06 |
| 4.5000000 | 6.0986353e-06 | 2.0794361e-06 |
| 4.7500000 | 5.8110371e-06 | 1.9811105e-06 |
| 5.0000000 | 5.5496537e-06 | 1.8917608e-06 |
| 5.2500000 | 5.3110354e-06 | 1.8102046e-06 |
| 5.5000000 | 5.0923150e-06 | 1.7354593e-06 |
| 5.7500000 | 4.8910894e-06 | 1.6667014e-06 |

TABLE 3

| $\alpha = N_c/N_s$ | $Y_o @ N_a = 3 \times 10^{16}$ | $Y_o @ N_a = 3 \times 10^{16}$ |
|---|---|---|
| 0.50000000 | 2.0226885e-05 | 1.4648398e-05 |
| 0.75000000 | 1.5399139e-05 | 1.1148451e-05 |
| 1.0000000 | 1.2537030e-05 | 9.0743104e-06 |
| 1.2500000 | 1.0612724e-05 | 7.6801600e-06 |
| 1.5000000 | 9.2194980e-06 | 6.6709817e-06 |
| 1.7500000 | 8.1596633e-06 | 5.9034214e-06 |
| 2.0000000 | 7.3241990e-06 | 5.2984395e-06 |
| 2.2500000 | 6.6475555e-06 | 4.8085218e-06 |

TABLE 3   (continued)

| $\alpha = N_c/N_s$ | $Y_o @ N_a = 3 \times 10^{16}$ | $Y_o @ N_a = 3 \times 10^{16}$ |
|---|---|---|
| 2.5000000 | 6.0877463e-06 | 4.4032386e-06 |
| 2.7500000 | 5.6165406e-06 | 4.0621323e-06 |
| 3.0000000 | 5.2142104e-06 | 3.7709088e-06 |
| 3.2500000 | 4.8665300e-06 | 3.5192616e-06 |
| 3.5000000 | 4.5629693e-06 | 3.2995624e-06 |
| 3.7500000 | 4.2955597e-06 | 3.1060392e-06 |
| 4.0000000 | 4.0581550e-06 | 2.9342402e-06 |
| 4.2500000 | 3.8459362e-06 | 2.7806752e-06 |
| 4.5000000 | 3.6550694e-06 | 2.6425677e-06 |
| 4.7500000 | 3.4824655e-06 | 2.5176806e-06 |
| 5.0000000 | 3.3256069e-06 | 2.4041908e-06 |
| 5.2500000 | 3.1824202e-06 | 2.3005973e-06 |

## Controlling Punch-through and Avalanche Breakdown Voltage

There are two voltage breakdown phenomenon that plague the success of short channel FET technology. Punch-through occurs when the depletion boundary surrounding the drain touches the depletion boundary surrounding a grounded source. This condition causes injection to occur at the source-substrate junction. Impact ionization occurs when drain voltage reaches a value that stimulates the generation of electron-hole pairs at the junction between the drain diffusion and substrate. Electron-hole pair generation gives rise to an avalanche break-down mechanism that produces a rapid increase in drain current. Substrate current flows when avalanche breakdown occurs in support of the increase in drain current.

According to the invention, substrate dopant level and the subdiffusion-drain implant doping factor $K_d$, may be used simultaneously to control both voltage breakdown mechanisms.

Referring now to Figure 8 an FET structure having subdiffusion regions to minimize punch-through and avalanche breakdown is shown. P-doped substrate **11** has an acceptor concentration $N_a$. Source and drain regions **12** and **13** respectively are heavily doped N-type regions. N-doped channel **15** has doping concentration $N_d$. In a preferred embodiment channel **15** meets the requirements of a Fermi-FET Equation 3A, although a conventional FET may also be employed. Associated with source **12** and drain **13** are source and drain subdiffusion regions **28** and **29** respectively, having donor doping concentrations $N_d = K_d N_a$. It will be understood by those having skill in the art that punch-through and avalanche breakdown are more likely to occur at the drain rather than the source, so that a drain subdiffusion **29** alone may be employed.

The value of the subdiffusion implant doping factor $K_d$ will now be described. Increasing punch-through breakdown requires raising substrate doping $N_a$. On the other hand, break down voltage due to impact ionization is inversely dependant on substrate doping. The solution to this dilemma is to control the dopant concentration $K_d$ of the subdiffusion region, Figure 8, in the vicinity of the substrate such that the peak field crossing the substrate to subdiffusion junction is minimized for a given drain voltage. The ionization field of approximately $3 \times 10^5$ Volts per cm is eventually reached for some drain voltage. The object is to operate Fermi-FET devices below this field value with as high a drain voltage as possible. Equation **33** below describes avalanche break-down as a function of the ionizing field $E_i$, substrate doping $N_a$, and Diffusion dopant factor $K_d$.

$$V_A = \frac{E_i^2 e_s}{2\, q N_a} \left( \frac{K_d + 1}{K_d} \right) \tag{33}$$

$$V_P = V_0 \left[ \left( \frac{L}{\sqrt{\dfrac{2 e_s V_0}{q N_a} \left( \dfrac{K_d}{K_d + 1} \right)}} - 1 \right)^2 - 1 \right] \tag{34}$$

$$K_d = \frac{N_d}{N_a} \qquad (35)$$

$$W_{no} = \sqrt{\frac{2e_s(V_0 + V_p)}{q\,N_a\,K_d\,(K_d+1)}} \quad \text{Minimum Depth For Subdiffusion} \qquad (36)$$

$$V_0 = \frac{KT}{q}\,Ln\!\left(\frac{K_d\,Na^2}{N_i^2}\right) \qquad \textbf{Contact Potential} \qquad (37)$$

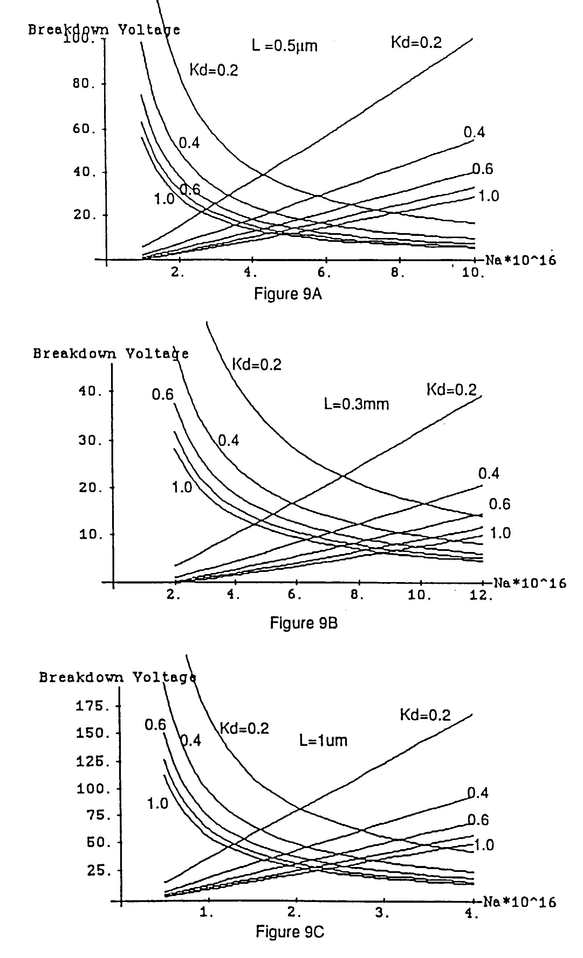

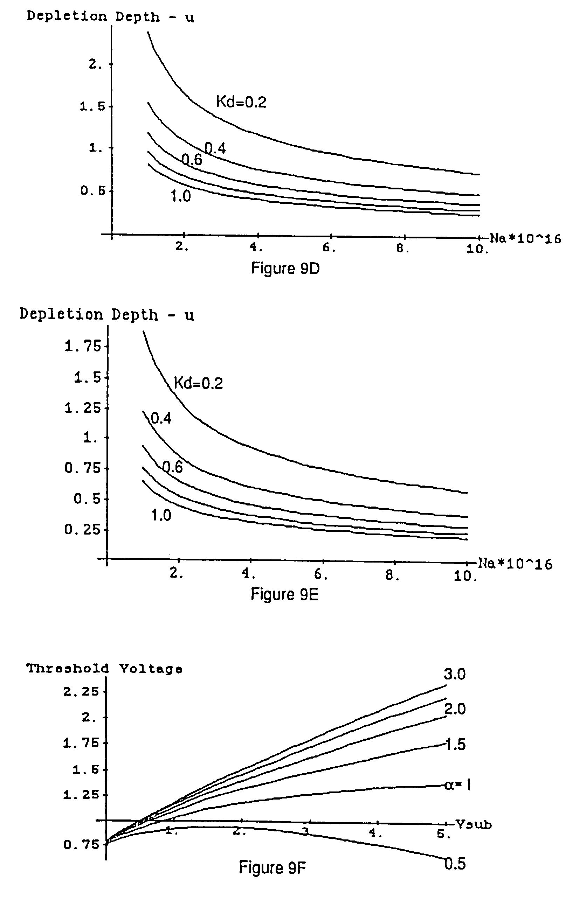

Equation (34) describes breakdown voltage $V_p$ due to the punch-through mechanism. The dependance of these breakdown mechanisms on substrate doping have opposite effects. One voltage increases while the other decreases. Maximum substrate doping occurs when Equations 34 and 35 are equal for a given subdiffusion concentration factor $K_d$. The drain sub-diffusion concentration factor $K_d$, for dopant concentration below the depth of the implanted channel region of the Fermi-FET, has a pronounced effect on drain breakdown voltage. This effect is illustrated in Figure 9A. Break-down is illustrated for several values for the concentration factor $K_d$. The nominal value $E_i$ for silicon is $2.5\times10^5$ V/cm at room temperature for the computed range of substrate doping $N_a$. Channel length L was $0.5\mu$. The minimum value for the subdiffusion implant depth $W_{no}$, (Figure 8), was computed assuming complete depletion at a drain voltage $V_d = 10V$ and 6V and is defined in Figure 9D and 9E respectively as a function of $N_a$ and $K_d$.

Referring to Figure 9A, both punch-through (rising curve) and avalanche breakdown voltage (falling curve) are shown as a function of $K_d$ and $N_a$. Their intersection specifies the maximum substrate doping level $N_a$ that simultaneously maximizes both breakdown voltages. Factor $K_d$ is shown in the range $0.2 < K_d < 1$. Higher breakdown voltage occurs when $K_d=0.2$. The channel is $0.5\mu$ long. It is apparent that a breakdown of 20 Volts is quite possible for this channel length. Ionization field $E_i = 2.5\times10^5$ V/cm.

Referring to Figure 9B both punch-through (rising curve) and avalanche breakdown voltage (falling curve) are shown. Their intersection specifies the maximum substrate doping level $N_a$ that maximizes both breakdown voltages. $K_d$ is shown in the range $0.2 < K_d < 1$. The highest breakdown voltage occurs when $K_d=0.2$. The channel is $0.3\mu$ long. It is apparent that a breakdown of 20 Volts is quite possible for this channel length.

Referring now to Figure 9C both punch-through (rising curve) and avalanche breakdown voltage (falling curve) are shown for a channel $L=1\mu m$. Figures 9D and 9E illustrate the minimum depth $W_{no}$ of the sub-diffusion region given 10 and 6 Volts on the drain for full depletion respectively. The highest running parameter is $K_d = 0.2$. The lowest is $K_d = 1.0$

Subdiffusion concentration factor $K_d$ should correspond approximately to twice the channel length L in number value. For example, if $L=0.5\mu$ then $K_d=1$. Under these circumstances, break-down voltage is about 10V for $E_i=2.5\times10^5$V/cm. The nominal substrate dopant concentration $N_a$ is about $4.6\times10^{16}$ cm$^{-3}$ for a channel length, $L=0.5\mu$, $N_a=8\times10^{16}$ for $L=0.3\mu$, and $N_a=2\times10^{16}$ for a channel length of $1\mu m$.

The channel implant factor $\alpha$ for the Fermi-FET is based on substrate concentration $N_s$ and the desired channel depth $Y_0$. The nominal value for $\alpha$ is about 2.0. The heavily doped drain and source contact diffusions, Figure 8, should have the same depth as the channel, and have resistance less than $200\Omega$ per square. Some latitude in this depth is provided by the choice of the channel implant factor $\alpha$. For example, the source and drain contact diffusions may be up to twice as deep as the channel depth $Y_0$.

The Fermi-FET body effect, threshold voltage variation with substrate voltage, is dramatically influenced by the channel implant factor $\alpha$. This effect with factor $\alpha$ is unique to the Fermi-FET and is illustrated in Figure 9F for $N_s=N_a = 5\times10^{16}$/cm$^3$. Figure 9F illustrates threshold voltage as a function of substrate voltage given $N_a=5\times10^{16}$ and channel factor $\alpha$ as the running parameter; $\alpha=a*n$, $a=0.5$. Note that threshold is fairly flat if $\alpha=0.7$, $T_{ox}=120$Å.

Ohmic-Contact Junction Potential Compensation

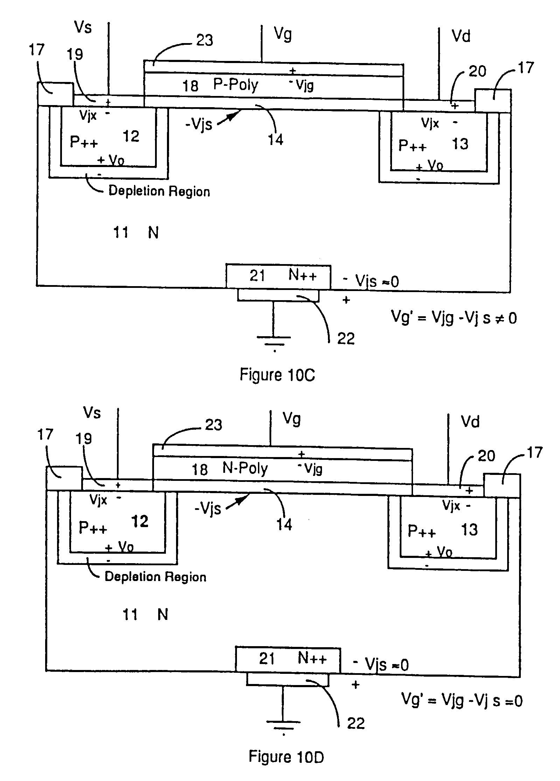

The effect of junction potentials of ohmic metal semiconductor contacts on threshold voltage and FET design will now be described. Figures 10A-10D illustrate various contact potentials that occur at the substrate-metal, diffusion-metal, and polysilicon gate-metal junctions. Figures 10A-10B illustrate N-channel devices and Figures 10C-10D illustrate P-channel devices.

The analysis presented heretofore assumes that drain, source, and gate voltages are referenced to the substrate potential. No provisions were made to include effects of metal contact potentials. It will become apparent from the following analysis that metal-polygate contact potential may be employed to compensate for metal-substrate flat-band voltage for both conventional and Fermi-FET devices. It will be shown that the doping polarity and concentration of the polysilicon gates, for both P- and N-channel devices may be chosen to compensate for substrate contact potential, thus eliminating this undesired source of threshold voltage.

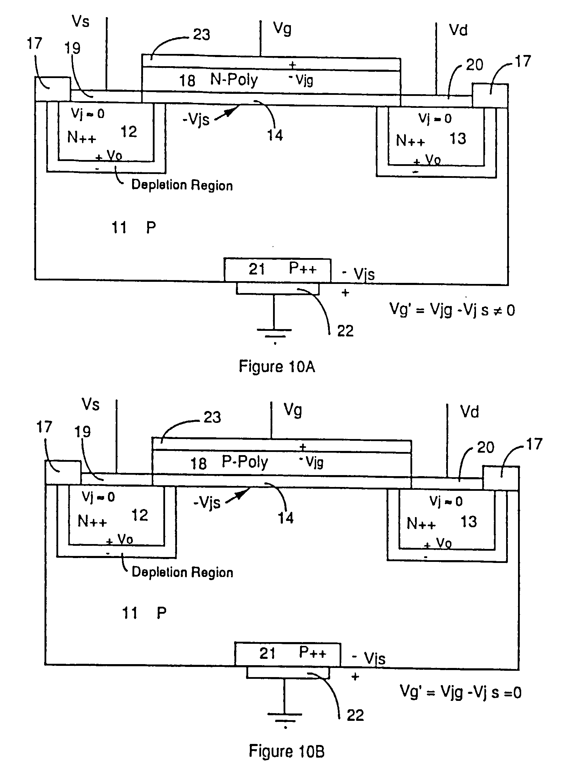

Referring to the N-channel technology, Figures 10A and 10B, contact to the substrate **11** is made by depositing metal **22** on a heavily doped P++ region **21** provided at the surface of the substrate **11**. A potential is developed across this P++ metal junction. The potential $V_{jx}$ is given below for metal to P- and N-type diffusions.

$$V_{jxp} = \frac{KT}{q} \ln\left(\frac{N^{\wedge} N_a}{N_i^2}\right) \qquad\qquad (38A)$$

$$V_{jxn} = \frac{KT}{q} Ln\left(\frac{N^{\wedge}}{N_d}\right) \qquad\qquad (38B)$$

$N_a$ is the acceptor concentration of the P++ pocket, $N_d$ is the donor concentration, and $N^{\wedge}$ is the effective density of conduction electrons in the contacting metal. The depletion depth within the P++ pocket region, resulting from metal contact, must be shallow by design to allow electron tunneling to occur in order to achieve Ohmic-contact properties of the metal-semiconductor junction. Depletion depth within the P++ pocket region is approximated by:

$$X_d = \sqrt{\frac{2e_s V_j}{qNa}\left(\frac{N_d^{\wedge}}{N_d^{\wedge} + Na}\right)} \qquad\qquad (39)$$

This depletion depth needs to be less than about $1.5 \times 10^{-6}$ cm in order to support the tunneling mechanism. Assuming $N_d^{\wedge} = 10^{21}$ cm$^{-3}$ and $N_a = 10^{19}$ cm$^{-3}$, then $V_{jx} = 1.17$ Volts, $X_d = 1.17 \times 10^{-6}$ cm, and the electric field at the junction is $qN_a X_d/e_s = 1.87 \times 10^6$ V/cm. A significant result is realized when the aluminum - substrate contact is grounded. This ground connection places the substrate potential below true ground potential. i.e. $-V_{js}$.

Accordingly, to assess true MOSFET threshold voltage one of the quiescent substrate to gate voltage must be considered. Referring to Figure 10A, the N-polysilicon gate-metal contact potential, $KT/q \ln(N^{\wedge}/N_d)$, is negligible, 150mv, and assumed to be small compared to $V_{js}$. Therefore grounding the gate yields a net positive gate to substrate voltage $V_{js} = 1.02$ Volts. Therefore the total MOSFET threshold voltage is reduced by the difference in contact potential $V_{js}$-$V_{jg}$. Given a grounded source N-channel Fermi-FET provided with a N-poly gate, threshold voltage $V_t$ would be $V_t = 2\phi_f$-$V_{js}$ and quite likely, threshold voltage will have a net negative value.

Referring now to Figure 10B, it is shown that the poly-gate **18** is doped P++. If the doping density of the polysilicon gate body region is identical to the substrate doping, and aluminum is used in both cases for contacts **22** and **23**, the polysilicon-aluminum contact potential will match the metal-substrate junction voltage $V_{jx}$. For this case, when the gate electrode **23** is grounded, the net contact induced threshold potential is $V_{jg}$ - $V_{js}$ = 0. Thus, no extraneous threshold potential exists, due to contacts, for any N-channel MOSFET configured with a P-polysilicon gate. The grounded source Fermi-FET device will simply have a threshold voltage $V_t = 2\phi_f$. Thus, an N-channel Fermi-FET structure needs a P-polysilicon gate to eliminate contact potentials from affecting threshold voltage.

The unconnected source and drain diffusion potential $V_j$ of the N-channel device is $V_j = V_0 - V_{js}$ where $V_0$ is the source or drain diffusion-substrate junction potential. The potential contour integral through the substrate, from contact **19** to contact **22** is zero if the same metal is used for both contacts. Grounding the diffusion - aluminum contact and substrate contact slightly reverse biases the diffusion - substrate junction.

Referring now to Figures 10C and 10D, a P-channel device is illustrated. Substrate contact is made by depositing aluminum **22** on an N++ pocket **21** implanted at the surface of an N-type substrate **11**. The junction potential $V_j$ of this Ohmic contact is given by Equation 38B since both materials are majority N-type. Therefore, grounding the aluminum contact **22**, places the substrate surface, under the gate, slightly below ground potential.

Referring to Figure 10C an aluminum contact 23 is made to a P-polysilicon gate. A junction potential $V_{jg}$ is developed across this contact that is similar in value to $V_{js}$ developed at the P-substrate-aluminum contact Figure 10B. Therefore, grounding the P-channel gate places the gate potential, $-V_{jg}$ below the surface potential of the substrate. The effect is to lower threshold voltage of the P-channel device by this junction potential. This offset in threshold voltage is eliminated by the structure shown in Figure 10D. In that structure an N-poly gate is used with a P-channel device. Any junction potential $V_{jp}$ developed across the aluminum - N-polysilicon junction can be made to be identical to the aluminum - substrate junction potential $V_{js}$. Grounding the aluminum contact on the N-poly gate eliminates gate to substrate potential and therefore no extraneous threshold voltage term exists due to metal contacts.

In conclusion, a significant contact potential exists between aluminum and P++ semiconductor material. In order to avoid introducing this contact potential as part of the threshold voltage, the following FET conditions must be met: N-channel FET's require a P-polysilicon gate, while P-channel FET's require a N-polysilicon gate.

The above described matching of implant doping eliminates extraneous threshold voltage as well as thermally introduced variations. It will be understood by those having skill in the art that the prior art has ignored or not totally understood the full implications of metal - semiconductor contact potentials (flat-band voltage).

**Threshold Voltage Sources - Summary**

Equations (40) and (46) reveal all important sources of threshold voltage for N- and P-channel FET devices.

N-Channel Technology

$$V_t = \phi_s + \frac{1}{Ci}\sqrt{2\,e_s\,q\,N_a\,\phi_s}\ -V_{cs}\ +V_{cg} \tag{40}$$

$$V_{cs} = \frac{KT}{q}\ln\left(\frac{N^\wedge N_a}{N_i^2}\right) \tag{41}$$

$$\phi_s = \frac{KT}{q}\ln\left(\frac{N_a}{N_i}\right)^2 = 2\phi_f \tag{42}$$

$$V_{cg} = 0 \text{ if metal gate} \tag{43}$$

$$V_{cg} = \frac{KT}{q}\ln\left(\frac{N^\wedge}{N_d}\right) \text{ if N-Poly} \tag{44}$$

$$V_{cg} = \frac{KT}{q}\ln\left(\frac{N^\wedge N_a}{N_i^2}\right) \text{ if P-Poly} \tag{45}$$

P-Channel Technology

$$V_t = -\phi_s - \frac{1}{Ci}\sqrt{2e_s\,q\,N_d\,\phi_s}\ -\ V_{cs}\ +\ V_{cg} \tag{46}$$

$$\phi_s = \frac{KT}{q}\ln\left(\frac{N_a}{N_i}\right)^2 = 2\phi_f \tag{47}$$

$$V_{cs} = \frac{KT}{q}\ln\left(\frac{N^\wedge}{N_d}\right) \tag{48}$$

$$V_{cg} = 0 \text{ if metal gate} \tag{49}$$

$$V_{cg} = \frac{KT}{q}\ln\left(\frac{N^\wedge}{N_d}\right) \text{ if N-Poly} \tag{50}$$

$$V_{cg} = \frac{KT}{q}\ln\left(\frac{N^\wedge N_a}{N_i^2}\right) \text{ if P-Poly} \tag{51}$$

For the conventional grounded source enhancement FET, there are four separate threshold voltage terms. From left to right they are; surface potential $\phi_s$, oxide potential $V_{ox}$, flat-band voltage at the substrate-metal Ohmic contact $V_{cs}$, and flat-band voltage at the polysilicon gate Ohmic contact $V_{cg}$. Comparing Equation 40 with Equation 46, for N- and P-channel devices, it is evident that the polarity of both flat-band voltage terms is unaltered. Their magnitudes however are different.

Fermi-FET device design according to the present invention completely eliminates oxide potential $V_{ox}$, the second term in Equations 40 and 46. However if the channel of the Fermi-FET is implanted with a dose greater than the nominal value, a fraction of the oxide potential term reappears but with a polarity opposite that indicated in Equation 40 and 46, as will be described below in connection with modifying Fermi-FET threshold voltage.

By examining Equations 40 and 46 it may be seen that threshold voltage for the Fermi-FET reduces to surface potential $\phi_s$ if both substrate and poly-gate flat-band voltages cancel one another. Equations 43 through 45 give expressions for poly-gate flat-band voltage $V_{cg}$ for N-channel devices given; a metal gate, and $N^+$ or $P^+$ polysilicon gates. Equations 48 through 51 give the appropriate expressions for p-channel devices. The net flat-band voltage, $V_{fb} = V_{cs} - V_{cg}$, approaches zero if the N-channel device is provided with a P-poly gate and the P- channel device is provided with an N-poly gate. Note that the dopant concentration at the surface of the poly gates must be high enough to achieve ohmic-metal contacts. The intrinsic carrier concentration $N_i^*$ of polysilicon is greater than that in crystalline silicon by about an order of magnitude. It is estimated that that the intrinsic carrier concentration $N_i^*$ in polysilicon is about $1.8 \times 10^{11} cm^{-3}$ at 300 degrees Kelvin. This value should be used when calculating flat-band voltage at metal - poly gate junctions.

Finally, it will be understood from the above analysis that conventional N- and P-channel FET devices should avoid use of metal gates. Instead they should be provided with contra-doped poly gates in order to achieve symmetric fabrication and equal threshold voltage. However, only the Fermi-FET device design eliminates oxide voltage from the threshold expression thereby attaining all of the performance advantages previously described.

The above analysis may be applied to specific examples as follows:

Case 1:

Metal gate P- and N-channel MOS devices. Threshold voltage for metal gate N- and P-channel devices becomes;

N-Channel

$$V_{tn} = \phi_s + \frac{1}{C_i} \sqrt{2\, e_s\, q\, N_a\, \phi_s} - V_{cs}$$

P-Channel

$$V_{tn} = -\phi_s - \frac{1}{C_i} \sqrt{2\, e_s\, q\, N_d\, \phi_s} - V_{cs}$$

$$C_i = \frac{e_i}{T_{ox}}$$

Flat-band voltage at the N-channel - substrate contact $V_{cs}$ is approximately 1.0 Volt, and depends on substrate acceptor concentration $N_a$. For the P-channel device, $V_{cs}$ is about 0.2V depending on donor concentration $N_d$, assuming that surface potential $\phi_s = 2\phi_f$ and therefore about 0.7V. For the N-channel device, threshold voltage becomes;

$$V_{tn} = -0.3 + \frac{1}{C_i} \sqrt{2\, e_s\, q\, N_a\, \phi_s}$$

Threshold voltage for the P-channel device becomes;

$$V_{tn} = -0.9 - \frac{1}{C_i} \sqrt{2\, e_s\, q\, N_d\, \phi_s}$$

The oxide potential term is all that remains to control threshold voltage. For the N-channel case, oxide potential needs to be about 1.0 V at inversion. Two options are available to attain this voltage; i.e. use thick oxide, and/or implant additional acceptor ions at the channel surface. This solution for the N-channel threshold voltage yields a device very sensitive to short channel and hot electron effects. The P-channel device has a different problem. Threshold voltage is too high even if oxide potential is zero. The only practical solution for a conventional P-channel device is to use an N-poly-gate to eliminate flat-band voltage effects. The result is;

$$V_{tp} = -0.7 - \frac{1}{C_i} \sqrt{2\, e_s\, q\, N_d\, \phi_s}$$

<u>Case 2:</u>

N-Poly gates used for both P- and N-channel devices.

As in Case 1, the net flat-band voltage is zero for the p-channel device. Its threshold voltage expression reduces to the following:

$$V_{tp} = -\phi_s - \frac{1}{C_i} \sqrt{2\,e_s\,q\,N_d\,\phi_s}$$

To reduce the contribution of the oxide potential term, the surface of the substrate, in the channel region, can be compensated with donor ions to reduce the effects of the oxide potential term.

The N-channel device has a different problem. The net flat-band voltage ($-V_{cs}+V_{cg}$) is about 0.8 volts. Threshold voltage becomes:

$$V_{tn} = -0.1 + \frac{1}{C_i} \sqrt{2\,e_s\,q\,N_d\,\phi_s}$$

The oxide potential term can be adjusted as in Case 1 by increasing the donor concentration $N_a$ in the channel region. As in Case 1, this is a poor solution since the device is still sensitive to short channel and hot electron effects because of the large oxide potential term.

<u>Case 3:</u>

N-channel device with P-poly gate and P-channel device with N-poly gate.

These combinations eliminate flat-band voltage and lead to balanced threshold voltages for the P- and N-channel devices.

$$V_{tn} = \phi_s + \frac{1}{C_i} \sqrt{2\,e_s\,q\,N_a\,\phi_s}$$

$$V_{tn} = -\phi_s - \frac{1}{C_i} \sqrt{2\,e_s\,q\,N_d\,\phi_s}$$

Increasing substrate doping $N_a$ for the N-channel device and $N_d$ for the P-channel device, is one method to control punch-through voltage for short channel devices. Unfortunately this technique, when used for conventional FET devices, increases oxide potential thus requiring channel surface compensation to be used to minimize the effect.

<u>Case 4:</u>

Fermi-FET with contra doped polysilicon gates.

The threshold voltage for the N- and P-channel devices are;

$$V_{tn} = +\phi_s = 2\phi_f$$

$$V_{tp} = -\phi_s = -2\phi_f$$

This simplicity comes about since oxide potential is zero by design and all flat-band voltages are cancelled. Under these ideal circumstances, both P- and N-channel Fermi-FET's can be optimized for punch-through and avalanche breakdown and maximized for transconductance without affecting threshold voltage. Of great importance is the insensitivity to short channel effects including hot electron trapping. Finally, Fermi-FET devices fabricated with channel lengths as short as $0.3\mu$ should not require scaling down the standard power supply voltage of 5volts.

**Effective Channel Length In FETs**

Previous analysis employed an effective channel length $L^*$. The origin of this term will now be described in connection with the formation of a channel by application of gate voltage $V_s$ when the depletion regions already surround the drain and source diffusions.

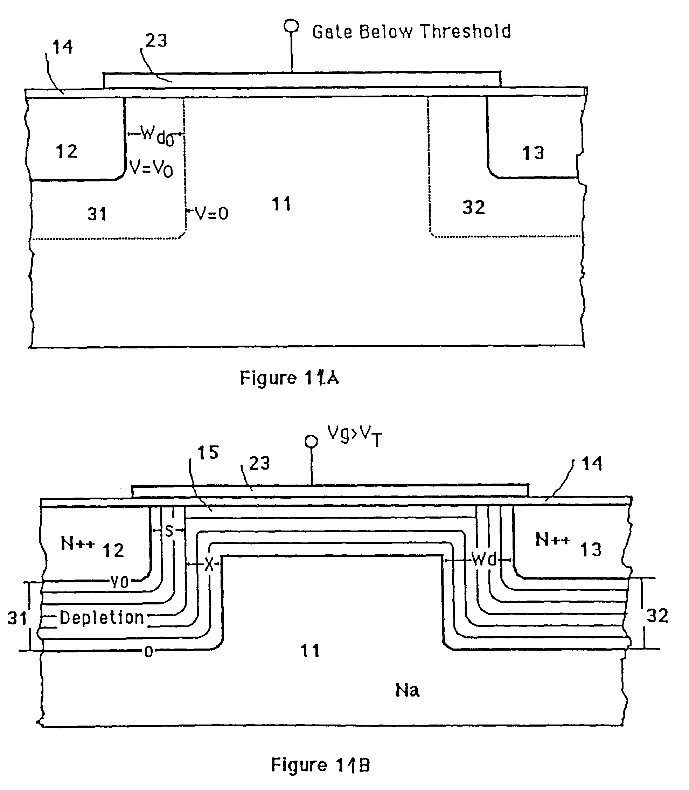

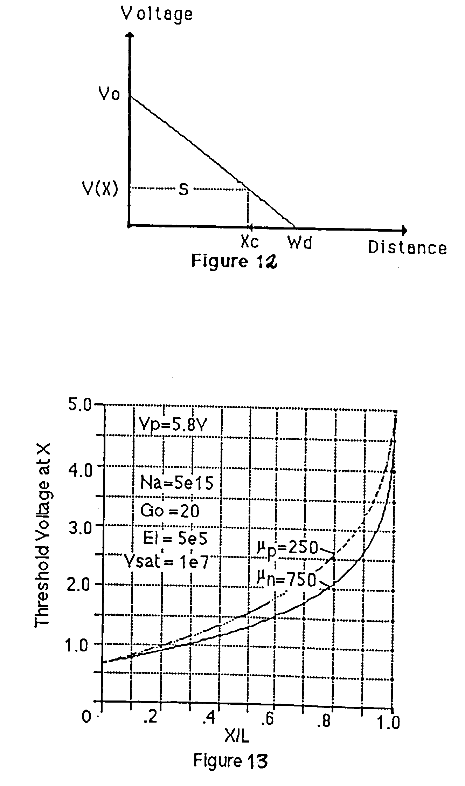

Referring now to Figure 11A, a MOSFET is shown having a depletion configuration without a channel, and with source **12** and drain **13** at ground potential and gate **23** below threshold. Figure 12A illustrates depletion regions **31** and **32** respectively in the substrate **11** surrounding the source and drain diffusions **12** and **13** respectively, resulting from these P-N junctions. A junction voltage $V_0$ appears on the diffusion at the stochastic junction between the diffusion and the substrate. This voltage is the result of achieving a constant Fermi potential across the junction. Junction voltage

$V_0$ is given below for an abrupt junction:

$$V_0 = \frac{KT}{q} \, Ln \, (\frac{N_a N_d}{Ni^2}) \tag{53}$$

The width $W_d$ of the depletion region (31 or 32) extending into the P-substrate from the drain or source diffusions is expressed as follows:

$$W_{dp} = \sqrt{\frac{2e_s V_0}{q} \left[ \frac{Nd}{Na(Na+Nd)} \right]} \tag{54}$$

If the donor concentration $N_d$ of the drain and source diffusions is much greater than acceptor concentration $N_a$, Equation 53 may be simplified. This simplification has been used above:

$$W_{dp} = \sqrt{\frac{2e_s V_0}{q N_a}} \tag{55}$$

The effect of these depletion regions upon channel formation will now be described. When gate voltage is applied, a uniform equipotential situation must occur that blends the equipotential contours, below the channel, with those contours already surrounding the diffusions. The result is illustrated in Figure 11B. In order to satisfy the equipotential criteria, the ionized P-region under the gate oxide 5 layer, as a result of gate voltage, does not extend all the way to the diffusions. Neither does the channel 15.

The penetration distance $X_c$ of the channel and its associated depletion region, into the drain and source depletion regions may be calculated as follows: Assuming an abrupt junction, Figure 12 illustrates the potential vs. distance from the stochastic junction of the source or drain depletion regions.

From Poisson's equation the following expression describes junction contact potential $V_0$ and potential $V(X)$ at position X measured from the end of the diffusion depletion region:

$$V_o = \frac{1}{2} q \frac{N_a}{e_s} W_{do}{}^2 \quad \text{Junction Contact Potential, and} \tag{56}$$

$$V(X) = \frac{1}{2} q \frac{N_a}{e_s} X^2 \quad \text{Voltage At Position } X_c, \tag{57}$$

where

$$V_o = KT/q \, L_n(N_a N_d/N_i{}^2), \tag{58A}$$

$$X = W_d - S, \text{ and} \tag{58B}$$

$$S = \text{Channel to diffusion spacing.} \tag{58C}$$

Solving Equations 56 and 57 for $V(X)$ in terms of $W_d$ and $V_0$:

$$V(X) = \left( \frac{X}{W_d} \right)^2 \tag{59}$$

Using the expression given by Equation 58B, Equation 59 becomes

$$V(X) = V_0 \left( 1 - \frac{S}{W_d} \right)^2 \tag{60}$$

Solving for S, the channel spacing distance S may be described in terms of depletion potential $V(X)$ at position X as follows:

$$S = W_{do} \left( 1 - \sqrt{\frac{V(X)}{V_0}} \right) \tag{61}$$

In order to establish the equipotential contours within the depletion region surrounding the drain and source diffusions, Figure 11B, Voltage $V(X)$ must be equal to the potential $\phi_s(X)$ at the ends of the channel region. The expression for $\phi_s$ has been previously obtained and is repeated below for convenience:

$$\phi_s = \frac{q}{2e_s} Na\, W_{dc}^2 \tag{62}$$

where $W_{dc}$ is the depth of the depletion region in the substrate below the oxide layer.

$$W_{dc} = \sqrt{\frac{2e_s}{q\, N_a} \phi_s} \tag{63}$$

Potential $\phi_s$ must be equal to diffusion potential $V(X)$. Thus from Equations 62 and 60:

$$\phi_s = V_0 \left( 1 - \frac{S}{W_{do}} \right)^2 \tag{64}$$

Solving Equation 64 for $S/W_d$, the following expression for the ratio of spacing to depletion width is obtained:

$$\frac{S}{W_{do}} = \left(1 - \sqrt{\frac{\phi_s}{V_0}}\right) \tag{65}$$

It will be understood from Equation 65 that channel spacing disappears when $\phi_s = V_0$. This condition requires that $N_p{}^* = N_d$ and is a situation that never occurs. In fact surface potential $\phi_s$ remains close to twice the Fermi potential, $2\phi_f$, for all practical values of gate voltage. Therefore Equation 65 may be conveniently approximated as:

$$S = W_{d0}\left( 1 - \sqrt{\frac{2\phi_f}{V_0}} \right) \tag{66}$$

Thus, at threshold, there is a channel-to-diffusion spacing at each end of the channel having the value specified by Equation 66. This channel-diffusion spacing distance $S$ may be minimized by diminishing depletion width $W_d$ by increasing acceptor concentration $N_a$ and or using lightly doped drain and source extension regions.

The analysis presented above assumes that no voltage is applied to the drain or source diffusions. If voltage $V$ is applied, the width of the diffusion depletion region increases. This effect is given by Equation 66.

$$W_d = \sqrt{\frac{2\,e_s}{q\, N_a} (V_0 + V)} \tag{67}$$

The above analysis may be repeated for an applied voltage $V_0$. The result is that spacing distance $S_d$, has the same form as Equation 66 except that depletion width $W_d > W_{do}$ due to voltage $V$.

$$S_d = W_d\left( 1 - \sqrt{\frac{2\phi_f}{V_0}} \right) \tag{68}$$

Accordingly, the effective channel length $L^*$ may be defined as follows:

$$L^* = L - (S_d + S_s), \tag{69}$$

where $S_s$ is the channel - diffusion spacing at the source, and $S_d$ is the channel - diffusion spacing at the drain.

For long-channel devices, $S_d$ and $S_s$ remain a small fraction of length $L$. However, for short-channel devices, $(S_s + S_d)$ can be a significant fraction of diffusion spacing length $L$ particularly when drain voltage is applied. The increase in voltage at the drain end of the channel, for example, resulting from drain voltage $V_d \le V_{dsat}$, is modified by the factor $2\phi_f/V_o$. Thus;

$$V(X) = (2\phi_f/V_o)V_d \tag{70}$$

At pinch-off, the following condition applies:

$$(2\phi_f/V_o)V_d = (V_g - V_t) \tag{71}$$

Solving Equation 70 for pinch-off voltage, one obtains a value greater than that reported in the literature:

$$V_p = (V_g - V_t)\frac{V_o}{2\phi_f} \tag{72}$$

When drain voltage exceeds pinch-off voltage, the depletion region around the drain diffusion expands and the end-of-the-channel region must slip back toward the source to maintain potential equilibrium, such that $V(X) = (V_g-V_t)$. This effect is the origin of drain conductance:

$$\frac{dI_d}{dV_d} = \frac{I_{d\,sat}}{L^*}\left(1 - \sqrt{\frac{2\phi_f}{V_0}}\right)\frac{e_s}{qNaW_d} \qquad (73)$$

Note that if $2\phi_f = V_o$, drain conductance would be zero. If acceptor concentration $N_a$ is too high, in the vicinity of the drain diffusion adjacent the channel, impact ionization break-down will occur at relatively low drain voltage.

To summarize the results of effective channel length $L^*$, it appears that in conventional FETs, the inversion channel never touches the drain or source diffusions due to the self depletion regions surrounding these diffusions in the vicinity of the intended channel region. Channel conduction requires injection at the source. It would also appear that the channel $L^*$ is shorter than L by the sum of the channel spacing factors $S_s+S_d$. Thus, the channel shrinking effect may be significant in short channel conventional FET devices if substrate doping is not increased to accommodate the effect. $L^*$ is the origin of threshold voltage variation with channel length and drain voltage. It will be understood by those having skill in the art that the Fermi-FET totally eliminates this problem. Finally, it would appear that in conventional FET designs that pinch-off voltage is greater than $(V_g-V_t)$ by the factor $V_o/2\phi_f$.

## Multiple Gate Fermi-FET

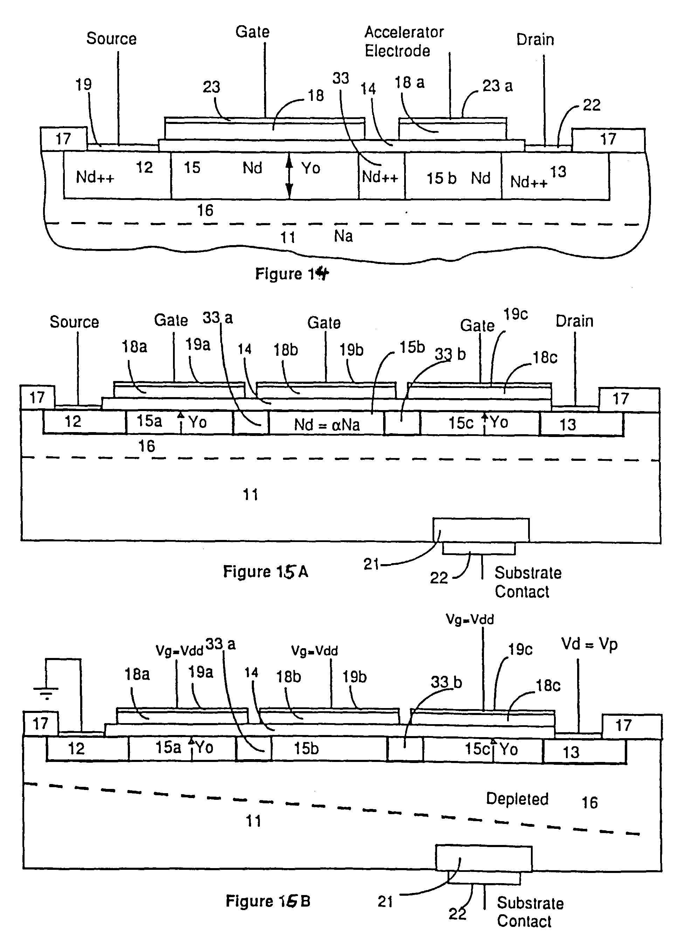

It will be understood by those having skill in the art that many applications of FET's require transistors to be connected in series. For example, CMOS (complementary MOS) logic technology requires connecting transistors in series to achieve the desired logic function while maintaining essentially zero idle power. For typical (non-Fermi) FET's, a series arrangement of transistors limits circuit performance in several ways. First, the threshold voltage for each of the series transistors, at best, corresponds to the threshold voltage along the gate of a single transistor whose total channel length is equal to the sum of the channel length's of all series transistors. In contrast, threshold voltage computed for the Fermi-FET is shown in Figure 13 as a function of position along the channel, for a typical P- and N-Channel device. It is apparent that threshold voltage remains below $V_{dd}/2$ along 80% of the total channel length. Based on the above, according to the invention a separate gate may be provided at the drain end of the channel in a Fermi-FET, whose potential is always at the full "on" value. In particular, the potential is the power supply voltage, $V_{dd}$, for N-channel devices and is at ground for P-channel devices. This gate is called an accelerator electrode and is illustrated in Figure 14, at **23a**. The polysilicon gate contact is illustrated at **18a**.

The threshold voltage for the remaining gate or gates located along the channel of a Fermi-FET device, is reduced substantially by use of the accelerator gate technique. Turn on delay is thereby minimized. Variance in threshold voltage of series connected transistors adds delay to the response time of the circuit and depends on the rise time of each of the gate input functions of a conventional CMOS configuration. The current capabilities of the series transistor configuration is diminished by factor N from the current conduction capability of a single transistor. It may be shown that switching frequency depends inversely on the square of the channel length and therefore on $N^2$, where N is the number of transistors connected in series. Therefore, response time varies directly with the square of the CMOS Fan-in factor, i.e. $N^2$. Part of the voltage drop along conventional FET transistors, includes differences in the depletion potential at both ends of the channel due to diffusions contacting the substrate. The Fermi-FET device completely eliminates this source of potential drop and therefore is better suited for CMOS than conventional FET devices.

The non-inversion mechanism of filling the self depleted implant channel of the Fermi-FET with conduction carriers, permits construction of the multi-gate FET design shown in Figure 15A. Figure 15B illustrates the multi-gate structure operating at pinch-off.

This plural gate structure is ideal for use in logic circuits or other applications requiring transistors connected in series, such as CMOS. The multi-gate structure has diffusion rails 33a,33b that separate one transistor channel region from another. These diffusion rails need not have contact metal as needed by individual transistors connected in series. The depth of the diffusion rails are the same as the source and drain regions and nominally have the same depth $Y_o$ as the implemented channel. The resistance of the source, drain and rail regions should be less than 200n per square. Alternatively, the source drain and rails may be deeper than the channel, for example, up to twice as deep. The diffusion rail design lowers diffusion capacity and eliminates one diffusion per transistor region thus minimizing space occupied by the circuit. The ends of each poly gate region overlap the rails of width W and length L to ensure proper gate induced channel filling with conduction carriers. Figure 15A does not illustrate a minimum geometry configuration. In that case, rail width W would be the same as channel length L.

## Substrate Bias Voltage

According to the invention, a DC voltage may be employed to bias the substrate of the Fermi-FET and allow the critical depth $Y_0$ of the implanted channel to be increased by the factor

$$\sqrt{(1+V_{sub}/\phi_s)} \ .$$

This depth increase improves initial drain conductance when bias is applied, and may be used to ease the shallow implant constraint. The increase in channel depth is necessary to insure that the Fermi-FET criterion is still met, i.e. there is no vertical electric field at the substrate-thin oxide interface at threshold of a grounded source Fermi-FET when the substrate bias is applied. The expression for variation of the critical implant depth $Y_0$ in terms of the substrate voltage $V_{sub}$ is:

$$Y_0 = \sqrt{\frac{2\,e_s}{q\,N_a}\left(\phi_s + |V_{sub}|\right)\frac{1}{\alpha\,(\alpha+1)}} \qquad (74)$$

Where $V_{sub}$ is the substrate voltage and the other parameters are as previously defined for Equation (3A).

Substrate bias voltage must have a polarity that reverse biases the diffusion-substrate junction. Accordingly for N-channel devices, substrate bias voltage is negative, while for P-channel devices, substrate bias voltage is positive. The value of substrate bias voltage must not be too high because this bias voltage linearly decreases the maximum drain voltage that initiates impact ionization at the diffusion-substrate junction. A substrate bias having absolute value of less than 2V is considered optimum.

Referring to Figures 1, 10 and 15, the substrate bias voltage $V_{sub}$ may be applied to substrate contact **22** rather than grounding this substrate contact as shown in these Figures.

The substrate bias voltage of the present invention provides the following advantages: First, while the Fermi-FET criterion is still maintained, the Fermi-FET criterion is satisfied at a deeper channel depth when substrate bias is applied. Accordingly, ease of manufacturability is obtained. Moreover, since in the preferred embodiment the source and drain diffusions have the same depth as the channel implant, the source and drain diffusion depths are preferably increased to equal the channel depth with substrate bias. Accordingly, the resistance of the source and drain diffusions, measured in ohms per square, is reduced. Diffusion capacitance at ground potential is also reduced since the depletion depth is increased by the substrate bias voltage. Substrate bias also eliminates the possibility of ground plane noise causing the substrate-diffusion junction to be randomly forward biased. Gate capacitance is also reduced because capacitance is inversely proportional to the channel depth.

The disadvantage of substrate bias is that the transconductance of the device decreases with increasing substrate bias. However, the toggle rate of the Fermi-FET device with substrate bias is essentially the same as a Fermi-FET without substrate bias because the diminished capacitive loading offsets the decrease in transconductance.

## Continuous Depletion Boundary To Reduce Punch Through

It has previously been described that substrate dopant level and the subdiffusion-drain implant dopant factor $K_d$ may be employed to simultaneously control both punch-through and avalanche breakdown of the Fermi-FET device. According to the invention punch-through of an FET device may be further reduced by insuring that the depth of the depletion region in the substrate at threshold is the same under the source and drain diffusions as it is under the implanted channel. In addition to controlling punch-through, this depletion depth equality insures that the depletion charge demanded by drain voltage does not conflict with the equilibrium space charge below the depleted channel. This interference would result if the source and drain diffusion regions had a depth which is greater than the depth of the channel.

It will be understood by those having skill in the art that in conventional MOSFET devices, the depth of the induced channel at strong inversion is in the order of 100Å. A practical minimum depth for diffusions to guarantee good metal contact is about 1000Å. Consequently, channel-diffusion depth equality to control punch-through in conventional MOSFET devices is not possible.

Punch-through in the Fermi-FET may occur when the depletion boundary surrounding the drain diffusion reaches across under the channel and touches a specific portion of the depletion boundary surrounding a grounded source. When this touching occurs, the source diffusion starts to inject minority carriers, and punch-through begins. Punch-through only occurs when the depth of the depletion regions below the source diffusion exceeds the depth of the depletion region developed in the substrate below the source end of the channel. This situation always occurs in MOS devices because of the shallow inversion layer.

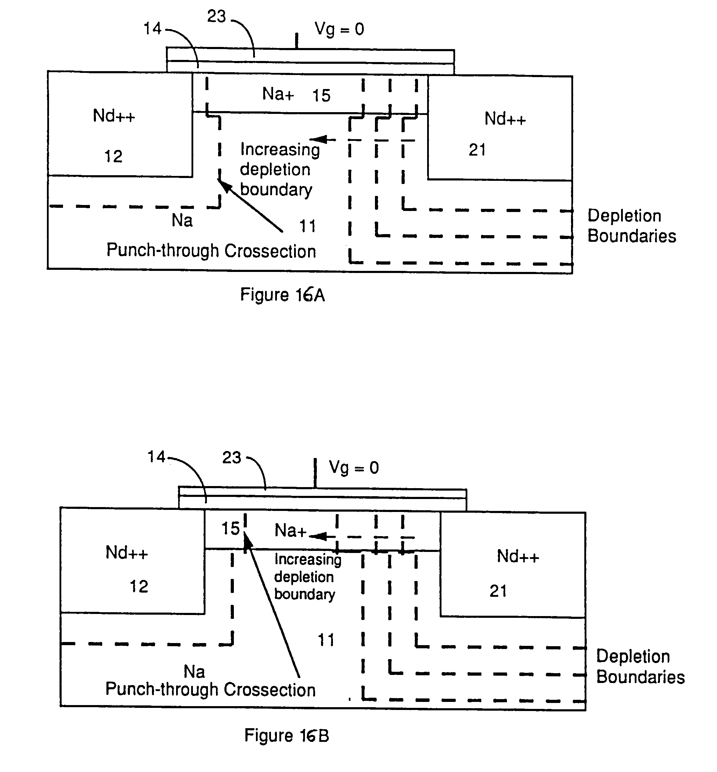

Figures 16A and 16B illustrate the punch-through mechanism for conventional MOS devices where the channel region is lightly doped compared to the substrate (Figure 16B), or more heavily doped than the substrate (Figure 16A). For a lightly doped channel region, punch-through occurs in the channel region when gate voltage is below threshold. This effect leads to high leakage current overriding the sub-threshold current. For the heavily doped channel region, punch-through first occurs below the channel region. The punch-through cross section is identified in Figure 16 and is the area of the source depletion boundary facing the drain diffusion where tangential depletion boundary interference may occur.

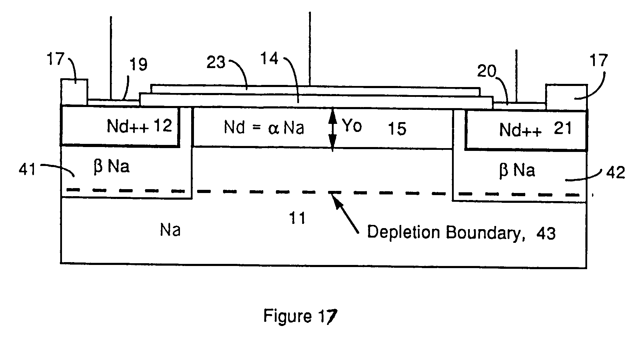

The Fermi-FET design allows the depth of the depletion region to have continuity at the source and the channel. Figure 17 illustrates a cross sectional view of a Fermi-FET. The depletion boundary **43** is illustrated between diffusions and below the channel implanted at the Fermi-FET depth $Y_0$ with zero drain and source voltage.

As shown in Figure 17, the diffusion depths of the source and drain **12** and **21** respectively are the same as the depth $Y_0$ of channel **15**. The continuous depletion boundary **43** eliminates punch-through cross section and is accomplished by use of substrate enhancement pocket regions **41** and **42** into which the source and drain diffusion regions **12** and **21** respectively, are implanted. The substrate pocket regions **41** and **42** have the same conductivity type as the substrate and have a doping factor β greater than the substrate. The depth of the depletion region below the source diffusion is given by:

$$W_{ds} = \sqrt{\frac{2\,e_s}{q\,N_s\,\beta}\,V_0} \tag{75}$$

where

$$V_0 = \frac{KT}{q}\ln\left(\frac{N_d^+\,\beta\,N_s}{N_i^2}\right) \qquad \text{If depletion depth is confined to the pocket region;}$$

$N_s =$ Substrate impurity concentration;
$N_d+ =$ Diffusion impurity concentration of opposite conductivity;
$N_i =$ Intrinsic carrier concentration; and
β = Pocket implant factor.

The depth of the depletion region below the Fermi channel is given by:

$$W_{dc} = \sqrt{\frac{2\,e_s}{q\,N_s}\,\phi_s\left(\frac{\alpha}{\alpha+1}\right)} \tag{76}$$

where

$$\phi_s = 2\,\phi_f + \frac{KT}{q}\ln(\alpha)\ ;$$

$$\phi_f = \frac{KT}{q}\ln\left(\frac{N_s}{N_i}\right)\ ;$$

α = Channel implant factor; and
$e_s =$ dielectric constant of the substrate.

Punch-through is prevented when $W_{ds} = W_{dc}$. This condition is true when

$$\beta = \frac{V_0}{\phi_s}\left(\frac{\alpha+1}{\alpha}\right) \tag{77}$$

In view of the definitions for $V_0$ and $\phi_s$, the solution to Equation (77) is a transcendental equation:

$$\beta = \frac{N_i^2}{N_s N_d^+} \left( \frac{\alpha N_s^2}{N_i^2} \right)^{\beta \left( \frac{\alpha}{\alpha+1} \right)} \qquad (78)$$

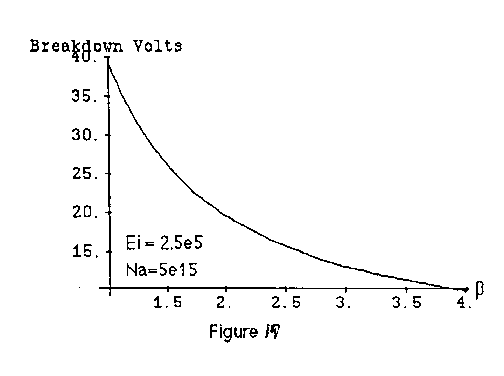

The solution points for pocket implant factor $\beta$ are illustrated in Figure 19 at the intersection points of the two functions plotted. The plot assumes $N_d^+$=1e20, $N_s$=5e15, $N_i$=1.5e10 and has the range $\alpha$=1-5.

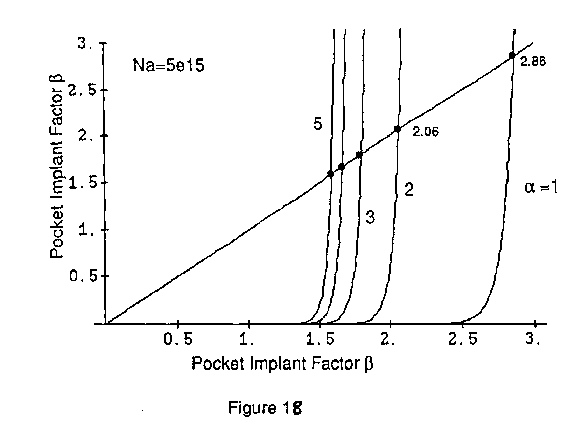

From Figure 18 it may be seen that the pocket implant factor $\beta$ is not very great. For example, for $\alpha$=1, $\beta$=2.86; for $\alpha$=2, $\beta$=2.06. This low value is desired since the only voltage breakdown mechanism left is avalanche breakdown that can occur at the diffusion-pocket junction below the drain diffusion. Figure 19 illustrates avalanche breakdown voltage plotted as a function of the pocket impurity concentration factor $\beta$ assuming the ionization field is 2.5e5 V/cm.

$$V_a = \frac{E_i^2 \, e_s}{2 \, q \, \beta \, N_s} \qquad (79)$$

For example, if substrate doping is 5e15 and $\beta$=2.86 then the pocket doping is 1.43e16. According to Figure 19, avalanche breakdown occurs at 14 volts when channel implant factor $\alpha$=1.0, $\beta$=2.86 and substrate doping is 5e15. Breakdown increases as $\alpha$ is increased and decreases with increasing substrate impurity. The nominal substrate impurity concentration $N_s$ is about 5e15 per cm$^3$. This value may be increased to 8e15 for channel lengths below 0.5$\mu$m. This range of substrate doping allows the depth $Y_0$ of the Fermi channel to be about 2000Å. Substrate bias and channel depth compensation for the bias voltage may be used to further increase this depth.

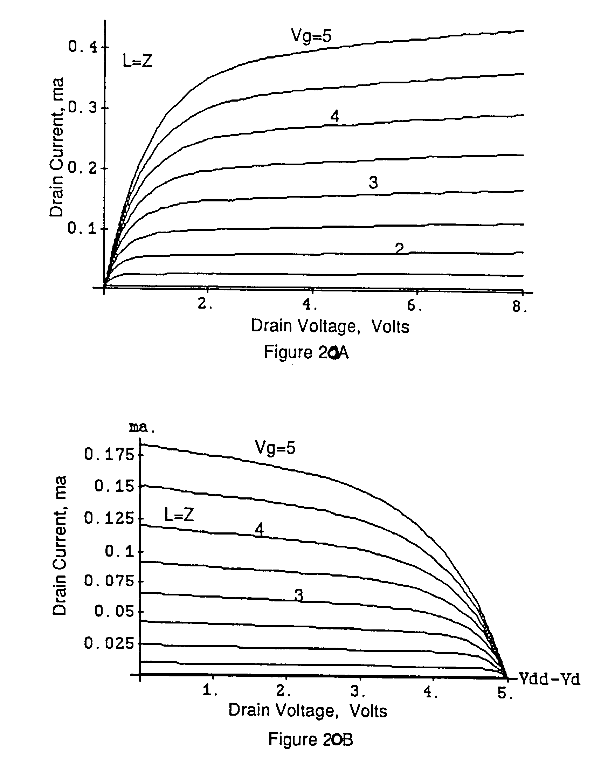

Figure 20A is a computer generated plot of an N-channel Fermi-FET with a channel length and width of 0.5$\mu$m, a channel implant factor of 2, a substrate dopant concentration of 5e15 acceptors per cm$^3$, a 120Å thin oxide layer, and a diffusion pocket doped at le16 acceptors per cm$^3$ and a channel depth of 1682Å. Figure 20B a plot of a P-channel Fermi-FET with a 0.5$\mu$m channel length and width. The same parameters were used except for opposite conductivity material.

The calculation of channel leakage current in the Fermi-FET will now be described. The principal leakage current flows between the source and drain when gate voltage is below threshold. This leakage current flows in the channel space charge region. The generation current density is essentially the intrinsic value $N_i$. For silicon, $N_i$=1.5e10 per cm$^3$. The space charge region below the channel is adjusted to terminate diffusion of carriers across the drain or source diffusions contacting the substrate region. Diffusion velocity in this region is limited by carrier lifetime. Leakage current in this region is several orders of magnitude below channel leakage current and therefore will be ignored.

Channel leakage current when drain voltage is applied may be calculated as follows: In this analysis, the source is assumed to be at ground potential. Channel leakage current is defined as $I_L$.

$$I_L = A \left[ q \, N_i \, V + q \, D_n \frac{dN}{dx} \right] \qquad (80)$$

Where area A is the product of the channel depth $Y_0$ and channel width Z. For purposes of this analysis it will be assumed that the drift and diffusion terms are equal. Therefore:

$$q N_i V = q D_n \frac{dN}{dx} \qquad (81)$$

Solving for dN/dx

$$\frac{dN}{dx} = \frac{N_i V}{D_n} \qquad (82)$$

But since;

$$D_n = \frac{KT}{q} \mu \text{ and} \qquad (83)$$

$$V = \mu E_1 \qquad (84)$$

Therefore

$$\frac{dN}{dx} = \frac{N_i E_1}{\frac{KT}{q}} \qquad (85)$$

28

Below threshold, the lateral field in the channel is $V_d/L$ where $V_d$ is drain voltage and L is channel length. Therefore;

$$\frac{dN}{dx} = \frac{N_i\, V_d}{L\frac{KT}{q}} \tag{86}$$

Calculating the diffusion current from equation (80):

$$\frac{I_L}{2} = Y_0 Z_q\, \mu N_i\, \frac{V_d}{L} \tag{87}$$

Care must be exercised when evaluating Equation (87). For a given drain voltage $V_d$, mobility $\mu$ is not arbitrary. In fact, when drain voltage is above a critical value, carriers in the depleted channel reach thermal saturation velocity $V_{sat}$ = 1e7 cm/sec. Thus it is more appropriate to express leakage current as a maximum in terms of saturation velocity, as follows:

$$I_L = 2Y_0 Z_q V_{sat} N_i \tag{88}$$

The expression for channel depth $Y_0$ is;

$$Y_0 = \sqrt{\frac{2e_s\phi_s}{qN_a\ \alpha\,(\alpha+1)}} \tag{89}$$

Evaluating Equation (88) for a channel width of 1e-4 cm, $N_a$=5e15, $N_i$=1.5e10, $\alpha$=1, $Y_0$=2.9e-5 cm, the leakage current is 1.5e-10 amps.

Unlike MOSFET devices, this leakage current is essentially independent of gate voltage below threshold voltage. Threshold is defined for the Fermi-FET as the value of gate voltage that is equal to surface potential $\phi_s$. The measured leakage current may be higher than that predicted. The primary reason is that after implantation of the channel, some lattice damage occurs which may increase the effective intrinsic carrier concentration.

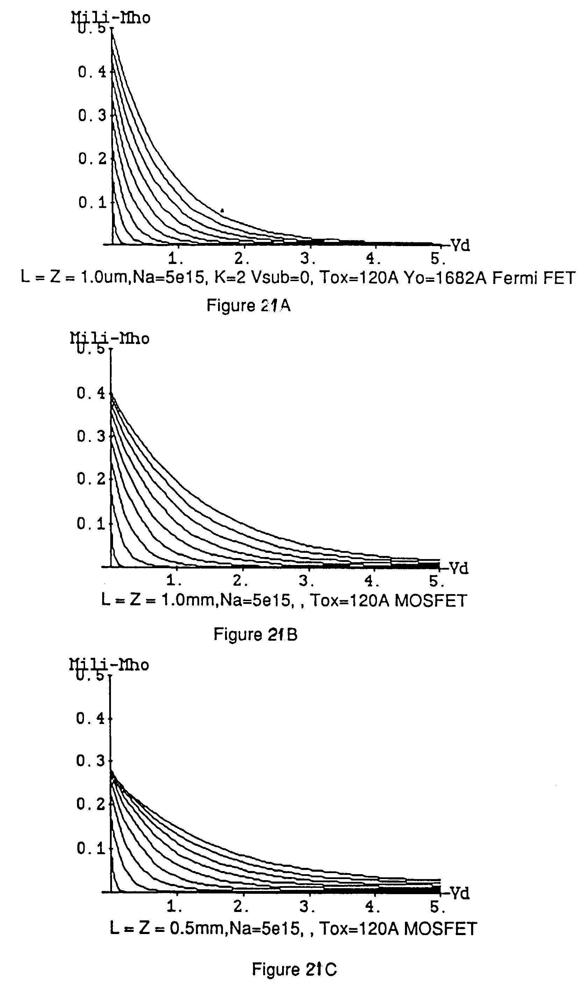

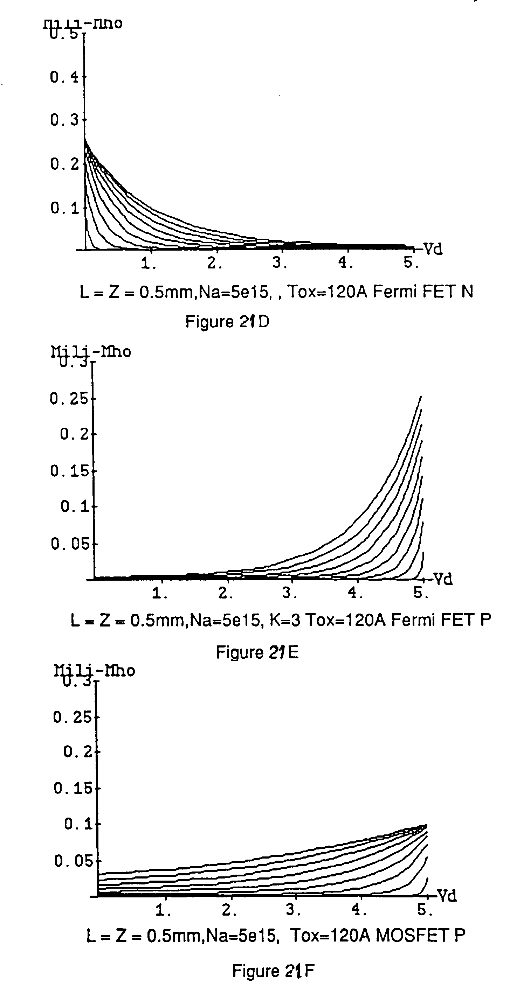

Figures 21A - 21F illustrate drain conductance as a function of drain and gate voltage for both the MOSFET and the Fermi-FET. A measure of quality is the ratio of initial drain conductance to drain conductance at a drain voltage of 2V. The Fermi-FET ratio is typically greater than 3 times the MOSFET ratio.

## Claims

1. A field effect transistor (10) comprising:

   a semiconductor substrate (11) of first conductivity type having a first surface and being doped at a first dopant density $N_s$, said semiconductor substrate (11) having an intrinsic carrier concentration $N_i$ at temperature T degrees Kelvin, and a dielectric constant $e_s$;
   source (12) and drain (13) regions of second conductivity type in said substrate (11) at said first surface;
   at least one channel (15) of said second conductivity type in said substrate (11) at said first surface between said source (12) and drain (13) regions, said at least one channel (15) being doped at a second dopant density;
   a gate insulating layer (14) on said substrate (11) at said first surface adjacent said at least one channel (15); and
   source (19) and drain (20) contacts and at least one gate contact (23) for contacting said source (12) and drain (13) regions and said gate insulating layer (14) respectively,
   characterised in that said second dopant density is a factor $\propto$ times said first dopant density $N_s$, said at least one channel having a predetermined depth $Y_o$ from said first surface, with $Y_o$ being equal to

   $$\sqrt{\frac{2\,e_s}{q\,N_s}\Big(\phi_s + |V_{sub}|\Big)\frac{1}{\alpha\,(\alpha+1)}}$$

   where $\phi_s$ is equal to $(KT/q)\ln(N_s/N_i)^2 + (KT/q)\ln\propto$, q is equal to $1.6\times10^{-19}$ coulombs, and K is equal to $1.38\times10^{-23}$ Joules/°Kelvin, and $V_{substrate}$ is the substrate bias voltage, if applied.

2. The field effect transistor (10) of claim 1 wherein $\propto$ equals 1 such that zero static field is produced perpendicular to said first surface between said at least one channel (15) and said gate insulating layer (14) at the threshold voltage of said field effect transistor (10).

3. The field effect transistor (10) of claim 1 wherein $\propto$ equals 1 such that said threshold voltage is twice the Fermi potential of said semiconductor substrate (11).

4. The field effect transistor (10) of claim 1 wherein said at least one channel (15) has a predetermined length from said source (12) to said drain (13), said gate insulating layer has a predetermined thickness, and $\propto$ equals 1 such that said threshold voltage is independent of said predetermined length and said predetermined thickness.

5. The field effect transistor (10) of any of the preceding claims, comprising:

   a substrate contact (22) for electrically contacting said substrate; and
   means for applying a substrate bias voltage $V_{substrate}$ to said substrate contact (22).

6. The field effect transistor of any of the preceding claims including a drain subdiffusion region (29) in said semiconductor substrate (11) adjacent said drain (13) region, said drain subdiffusion region (29) being of said second conductivity type and having a dopant density which is a factor times said first dopant density $N_s$, said factor being selected to simultaneously maximize punch-through breakdown and avalanche breakdown voltages between said drain (13) and said substrate (11).

7. The field effect transistor of claim 6, including a source subdiffusion region (28) in said substrate (11) adjacent said source (12) region, said source subdiffusion region (28) being of said second conductivity type and having a dopant density which is said factor times said first dopant density $N_s$.

8. The field effect transistor of any of the preceding claims, wherein said semiconductor substrate (11) comprises a first semiconductor material in monocrystalline form, having first conductivity type;

   and wherein said at least one gate contact (23) comprises said first semiconductor material in polycrystalline from, having said first conductivity type and being doped at said first dopant density $N_s$.

9. The field effect transistor of any of the preceding claims wherein said semiconductor substrate (11) comprises monocrystalline silicon having 100 orientation.

10. The field effect transistor of claim 1, wherein $\alpha$ equals 2.

11. The field effect transistor of any of the preceding claims, wherein said first dopant density $N_s$ is between $5\times10^{15}$ and $1\times10^{17}$ ions per cubic centimeter.

12. The field effect transistor of any of the preceding claims, wherein said source (12) and drain (13) regions have a predetermined depth from said first surface which is less than twice $Y_0$.

13. The field effect transistor of claim 12, wherein said source (12) and drain (13) regions have a predetermine depth from said first surface which is equal to $Y_o$.

14. The field effect transistor of any of the preceding claims, including:

   a substrate contact (22) for electrically contacting said substrate (11), said substrate contact (22) generating a substrate contact potential; and
   at least one semiconductor gate contact (23) for electrically contacting said at least one gate insulating layer (14), said semiconductor gate contact (23) being selected to have a conductivity type and dopant density which generates a gate contact potential which is equal and opposite to said substrate contact potential, whereby said gate and substrate contact potentials are neutralized.

15. The field effect transistor of claim 14, wherein said semiconductor gate contact (23) comprises said first semiconductor material in polycrystalline form, having said first conductivity type and being doped at said first dopant density N.

16. The field effect transistor of claim 14 or 15, wherein said semiconductor substrate (11) comprises monocrystalline silicon and wherein said gate contact (23) comprises polycrystalline silicon.

17. The field effect transistor of claim 14, 15 or 16, wherein said substrate contact (22) comprises a layer of metal on said substrate (11) and wherein said at least one semiconductor gate contact (23) includes a layer of the same metal on said at least one semiconductor gate contact (23).

18. The field effect transistor of claim 17, wherein said metal is aluminum.

19. The field effect transistor of claim 17 or 18, wherein said first dopant density $N_s$ is sufficiently high to form an ohmic contact with said metal.

20. The field effect transistor of any of the preceding claims, wherein said source (12) and drain (13) regions have a dopant density which is sufficiently high to permit ohmic metal contact thereto.

21. The field effect transistor of any of the preceding claims, wherein the resistance of said source (12) and drain (13) regions is less than $200\Omega$ per square.

22. The field effect transistor of any of the preceding claims wherein said gate insulating layer (14) and said at least one gate contact (23) slightly overlap said source and drain regions on said first surface.

23. The field effect transistor of any of the preceding claims wherein said gate insulating layer (14) is an oxide of said semiconductor substrate (11).

24. The field effect transistor of any of the preceding claims, including a plurality of channels (15,15a,15b,15c) separated from one another by rail regions (33,33a,33b).

25. The field effect transistor of claim 24, wherein said rail regions (33,33a,33b) comprise heavily doped diffusion rails having the same conductivity type as said plurality of channels (15,15a,15b,15c).

26. The field effect transistor of claim 24 or 25, wherein the gate contact (23a) nearest said drain contact (20) comprises an accelerator contact.

27. The field effect transistor of claim 26, wherein said accelerator contact (23a) is maintained at the same voltage as said drain contact (20).

28. The field effect transistor of claim 5, wherein said at least one channel (15) is N-type and wherein said substrate bias voltage is negative.

29. The field effect transistor of claim 5, wherein said at least one channel (15) is P-type and wherein said substrate bias voltage is positive.

30. The field effect transistor of claim 5, 28 or 29, wherein the absolute value of said substrate voltage is less than 2 volts.

**Patentansprüche**

1. Feldeffekttransistor (10), umfassend:

ein Halbleitersubstrat (11) eines ersten Leitfähigkeitstyps mit einer ersten Oberfläche, das mit einer ersten Dotierungsmitteldichte $N_s$ dotiert ist, wobei das Halbleitersubstrat (11) eine Trägerdichte in einem Eigenhalbleiter $N_1$ bei einer Temperatur von T Grad Kelvin aufweist sowie eine dielektrische Konstante $e_s$;
Quellen- (12) und Drain- (13) Bereiche eines zweiten Leitfähigkeitstyps in dem Substrat (11) auf der ersten Oberfläche;
mindestens einen Kanal (15) des zweiten Leitfähigkeitstyps in dem Substrat (11) auf der ersten Oberfläche zwischen den Quellen- (12) und Drain- (13) Bereichen, wobei der mindestens eine Kanal (15) mit einer zweiten Dotierungsmitteldichte dotiert ist;
eine Torisolationsschicht (14) auf dem Substrat (11) auf der ersten Oberfläche neben dem mindestens einen Kanal (15); und
Quellen- (19) und Drain- (20) Kontakte und mindestens einen Torkontakt (23) zum Kontaktieren der Quellen- (12) und Drain- (13) Bereiche bzw. der Torisolationsschicht (14),
dadurch gekennzeichnet, daß die zweite Dotierungsmitteldichte ein Faktor $\propto$ mal die erste Dotierungsmitteldichte $N_s$ ist, wobei der mindestens eine Kanal ein vorbestimmte Tiefe $Y_o$ zu der ersten Oberfläche aufweist, wobei $Y_o$ gleich

$$\sqrt{\frac{2e_s}{qN_s}\left(\Phi_s + |V_{sub}|\right)\frac{1}{\alpha(\alpha+1)}}$$

ist, wobei $O_s$ gleich $(KT/q)\ln(N_s/N_1)^2 + (KT/q)\ln\propto$ ist, q gleich $1{,}6\times10^{-19}$ Coulomb ist und K gleich $1{,}38\times10^{-23}$ Joule/° Kelvin ist, und $V_{substrat}$ die Substratvorspannung ist, falls angelegt.

2. Feldeffekttransistor (10) nach Anspruch 1, wobei $\propto$ gleich 1 ist, so daß ein statisches Nullfeld senkrecht zu der ersten Oberfläche zwischen dem mindestens einen Kanal (15) und der Torisolationsschicht (14) bei der Schwellenspannung des Feldeffekttransistors (10) erzeugt wird.

3. Feldeffekttransistor (10) nach Anspruch 1, wobei $\propto$ gleich 1 ist, so daß die Schwellenspannung das Zweifache des Fermipotentials des Halbleitersubstrats (11) ist.

4. Feldeffekttransistor (10) nach Anspruch 1, wobei der mindestens eine Kanal (15) eine vorbestimmte Länge von der Quelle (12) zu dem Drain (13) aufweist, die Torisolationsschicht eine vorbestimmte Dicke aufweist, und $\propto$ gleich 1 ist, so daß die Schwellenspannung unabhängig von der vorbestimmten Länge und der vorbestimmten Dicke ist.

5. Feldeffekttransistor (10) nach einem der vorangehenden Ansprüche, umfassend:

   einen Substratkontakt (22) zum elektrischen Kontaktieren des Substrats; und
   Mittel zum Anlegen einer Substratvorspannung $V_{substrat}$ an den Substratkontakt (22).

6. Feldeffekttransistor nach einem der vorangehenden Ansprüche, umfassend einen Drain-Subdiffusionsbereich (29) in dem Halbleitersubstrat (11) neben dem Drainbereich (13), wobei der Drain-Subdiffusionsbereich (29) vom zweiten Leitfähigkeitstyp ist und eine Dotierungsmitteldichte aufweist, die ein Faktor mal die erste Dotierungsmitteldichte $N_s$ ist, wobei der Faktor derart gewählt ist, daß gleichzeitig die Durchgreif- und Lawinendurchbruchspannungen zwischen dem Drain (13) und dem Substrat (11) maximiert werden.

7. Feldeffekttransistor nach Anspruch 6, umfassend einen Quellen-Subdiffusionsbereich (28) in dem Substrat (11) neben dem Quellenbereich (12), wobei der Quellen-Subdiffusionsbereich (28) vom zweiten Leitfähigkeitstyp ist und eine Dotierungsmitteldichte aufweist, die der genannte Faktor mal die erste Dotierungsmitteldichte $N_s$ ist.

8. Feldeffekttransistor nach einem der vorangehenden Ansprüche, wobei das Halbleitersubstrat (11) ein erstes Halbleitermaterial in monokristalliner Form umfaßt, das vom ersten Leitfähigkeitstyp ist;

   und wobei der mindestens eine Torkontakt (23) das erste Halbleitermaterial in polykristalliner Form umfaßt, das vom ersten Leitfähigkeitstyp ist und mit der ersten Dotierungsmitteldichte $N_s$ dotiert ist.

9. Feldeffekttransistor nach einem der vorangehenden Ansprüche, wobei das Halbleitersubstrat (11) monokristallines Silicium mit einer 100-Orientierung umfaßt.

10. Feldeffekttransistor nach Anspruch 1, wobei $\alpha$ gleich 2 ist.

11. Feldeffekttransistor nach einem der vorangehenden Ansprüche, wobei die erste Dotierungsmitteldichte $N_s$ zwischen $5\times10^{16}$ und $1\times10^{17}$ Ionen pro Kubikmeter beträgt.

12. Feldeffekttransistor nach einem der vorangehenden Ansprüche, wobei die Quellen- (12) und Drain- (13) Bereiche eine vorbestimmte Tiefe zu der ersten Oberfläche aufweisen, die geringer als zweimal $Y_o$ ist.

13. Feldeffekttransistor nach Anspruch 12, wobei die Quellen- (12) und Drain- (13) Bereiche eine vorbestimmte Tiefe zu der ersten Oberfläche aufweisen, die gleich $Y_o$ ist.

14. Feldeffekttransistor nach einem der vorangehenden Ansprüche, umfassend:

   einen Substratkontakt (22) zum elektrischen Kontaktieren des Substrats (11), wobei der Substratkontakt (22) ein Substratkontaktpotential erzeugt; und
   mindestens einen Halbleitertorkontakt (23) zum elektrischen Kontaktieren der mindestens einen Torisolationsschicht (14), wobei der Halbleitertorkontakt (23) so gewählt ist, daß er einen Leitfähigkeitstyp und eine Dotierungsmitteldichte aufweist, die ein Torkontaktpotential erzeugen, das dem Substratkontaktpotential gleich und entgegengesetzt ist, wodurch das Tor- und Substratkontaktpotential neutralisiert werden.

15. Feldeffekttransistor nach Anspruch 14, wobei der Halbleitertorkontakt (23) das erste Halbleitermaterial in polykristalliner Form umfaßt, das vom ersten Leitfähigkeitstyp ist und mit der ersten Dotierungsmitteldichte N dotiert ist.

16. Feldeffekttransistor nach Anspruch 14 oder 15, wobei das Halbleitersubstrat (11) monokristallines Silicium umfaßt und wobei der Torkontakt (23) polykristallines Silicium umfaßt.

17. Feldeffekttransistor nach Anspruch 14, 15 oder 16, wobei der Substratkontakt (22) eine Metallschicht auf dem Substrat (11) umfaßt und wobei der mindestens eine Halbleitertorkontakt (23) eine Schicht aus demselben Metall auf dem mindestens einen Halbleitertorkontakt (23) enthält.

18. Feldeffekttransistor nach Anspruch 17, wobei das Metall Aluminium ist.

19. Feldeffekttransistor nach Anspruch 17 oder 18, wobei die ersten Dotierungsmitteldichte $N_s$ ausreichend hoch ist, um einen ohmschen Kontakt mit dem Metall zu bilden.

20. Feldeffekttransistor nach einem der vorangehenden Ansprüche, wobei die Quellen- (12) und Drain- (13) Bereiche eine Dotierungsmitteldichte aufweisen, die ausreichend hoch ist, um einen ohmschen Metallkontakt damit zu ermöglichen.

21. Feldeffekttransistor nach einem der vorangehenden Ansprüche, wobei der Widerstand der Quellen- (12) und Drain- (13) Bereiche kleiner als 200$\Omega$ pro Quadrat ist.

22. Feldeffekttransistor nach einem der vorangehenden Ansprüche, wobei die Torisolationsschicht (14) und der mindestens eine Torkontakt (23) die Quellen- und Drainbereiche auf der ersten Oberfläche leicht überlappen.

23. Feldeffekttransistor nach einem der vorangehenden Ansprüche, wobei die Torisolationsschicht (14) ein Oxid des Halbleitersubstrats (11) ist.

24. Feldeffekttransistor nach einem der vorangehenden Ansprüche, welcher eine Mehrzahl von Kanälen (15, 15a, 15b, 15c) enthält, die voneinander durch Schienenbereiche (33, 33a, 33b) getrennt sind.

25. Feldeffekttransistor nach Anspruch 24, wobei die Schienenbereiche (33, 33a, 33b) schwer dotierte Diffusionsschienen vom selben Leitfähigkeitstyp wie die Mehrzahl von Kanälen (15, 15a, 15b, 15c) umfassen.

26. Feldeffekttransistor nach Anspruch 24 oder 25, wobei der Torkontakt (23a), der dem Drainkontakt (20) am nächsten liegt, einen Beschleunigungskontakt umfaßt.

27. Feldeffekttransistor nach Anspruch 26, wobei der Beschleunigungskontakt (23a) bei derselben Spannung wie der Drainkontakt (20) gehalten wird.

28. Feldeffekttransistor nach Anspruch 5, wobei der mindestens eine Kanal (15) vom N-Typ ist und wobei die Substratvorspannung negativ ist.

29. Feldeffekttransistor nach Anspruch 5, wobei der mindestens eine Kanal (15) vom P-Typ ist und wobei die Substratvorspannung positiv ist.

30. Feldeffekttransistor nach Anspruch 5, 28 oder 29, wobei der Absolutwert der Substratspannung weniger als 2 Volt beträgt.

**Revendications**

1. Transistor à effet de champ (10), comprenant :

    un substrat semiconducteur (11), d'un premier type de conductivité, ayant une première surface et étant dopé à une première densité de dopant $N_s$, ledit substrat semiconducteur (11) ayant une concentration des porteurs intrinsèques $N_1$ à une température de T degrés Kelvin, et une constante diélectrique $e_s$ ;
    une région de source (12) et une région de drain (13) d'un deuxième type de conductivité dans ledit substrat (11) sur ladite première surface ;
    au moins un canal (15), dudit deuxième type de conductivité dans ledit substrat (11) sur ladite première surface entre ladite région de source (12) et ladite région de drain (13), ledit au moins un canal (15) étant dopé à une deuxième densité de dopant ;
    une couche d'isolation de grille (14) sur ledit substrat (11), sur ladite première surface au voisinage immédiat dudit au moins un canal (15) ; et
    des contacts de source (19) et de drain (20), et au moins un contact de grille (23) pour permettre le contact entre ladite région de source (12) et ladite région de drain (13), et ladite couche d'isolation de grille (14),
    caractérisé en ce que ladite deuxième densité de dopant est $\alpha$ fois égale à ladite première densité de dopant $N_s$, ledit au moins un canal ayant une profondeur prédéterminée $Y_o$ à partir de ladite première surface, $Y_o$ étant égal à

$$\sqrt{\frac{2\,e_s}{q\,N_s}\left(\phi_s + |V_{sub0}|\right)\frac{1}{\alpha\,(\alpha+1)}}$$

    où $\phi_s$ est égal à $(KT/q)\ln(N_s/N_1)^2 + (KT/q)\ln\alpha$, q est égal à $1,6.10^{-19}$ coulombs et K est égal à $1,38.10^{-23}$ Joules/° Kelvin, et $V_{sub}$ est la tension de polarisation du substrat, si elle est appliquée.

2. Transistor à effet de champ (10) selon la revendication 1, dans lequel $\alpha$ est égal à 1, de sorte qu'un champ statique égal à zéro soit produit perpendiculairement à ladite première surface entre ledit au moins un canal (15) et ladite couche d'isolation de grille (14) à la tension de seuil dudit transistor à effet de champ (10).

3. Transistor à effet de champ (10) selon la revendication 1, dans lequel $\alpha$ est égal à 1, de telle sorte que ladite tension de seuil soit égale à deux fois le potentiel de Fermi dudit substrat semiconducteur (11).

4. Transistor à effet de champ (10) selon la revendication 1, dans lequel ledit au moins un canal (15) présente une longueur prédéterminée à partir de ladite source (12) jusqu'audit drain (13), ladite couche d'isolation de grille ayant une épaisseur prédéterminée, et $\alpha$ est égal à 1, de telle sorte que ladite tension de seuil soit indépendante de ladite longueur prédéterminée et de ladite épaisseur prédéterminée.

5. Transistor à effet de champ (10) selon l'une quelconque des revendications précédentes, comprenant :

    un contact de substrat (22), pour assurer un contact électrique dudit substrat ; et
    un moyen pour appliquer une tension de polarisation de substrat $V_{sub}$ audit contact de substrat (22).

6. Transistor à effet de champ selon l'une quelconque des revendications précédentes, comprenant une région de subdiffusion du drain (29) dans ledit substrat semiconducteur (11) au voisinage immédiat de ladite région de drain (13), ladite région de subdiffusion du drain (29) étant dudit deuxième type de conductivité et ayant une densité de dopant qui est égale au produit de ladite première densité de dopant $N_s$ par un facteur multiplicatif, ledit facteur multiplicatif étant sélectionné de façon à maximiser simultanément la tension de claquage par pénétration et la tension de claquage par avalanche entre ledit drain (13) et ledit substrat (11).

7. Transistor à effet de champ selon la revendication 6, qui comprend une région de subdiffusion de source (28) se trouvant dans ledit substrat (11) au voisinage immédiat de ladite région de source (12), ladite région de subdiffusion de source (28) étant dudit deuxième type de conductivité et ayant une densité de dopant qui est égale au produit de ladite première densité de dopant $N_s$ par ledit facteur multiplicatif.

**8.** Transistor à effet de champ selon l'une quelconque des revendications précédentes, dans lequel ledit substrat semiconducteur (11) comprend un premier matériau semiconducteur sous forme monocristalline ayant un premier type de conductivité ;

et dans lequel ledit au moins un contact de grille (23) comprend ledit premier matériau semiconducteur sous forme polycristalline, ayant ledit premier type de conductivité et étant dopé à ladite première densité de dopant $N_s$.

**9.** Transistor à effet de champ selon l'une quelconque des revendications précédentes, dans lequel ledit substrat semiconducteur (11) comprend du silicium monocristallin ayant une orientation 100.

**10.** Transistor à effet de champ selon la revendication 1, dans lequel $\alpha$ vaut 2.

**11.** Transistor à effet de champ selon l'une quelconque des revendications précédentes, dans lequel ladite première densité de dopant $N_s$ est comprise entre $5.10^{15}$ et $1.10^{17}$ ions par centimètre cube.

**12.** Transistor à effet de champ selon l'une quelconque des revendications précédentes, dans lequel ladite région de source (12) et la dite région de drain (13) ont une profondeur prédéterminée à partir de ladite première surface, qui est inférieure au double de $Y_o$.

**13.** Transistor à effet de champ selon la revendication 12, dans lequel lesdites régions de sources (12) et de drain (13) ont une profondeur prédéterminée à partir de ladite première surface, qui est égale à $Y_o$.

**14.** Transistor à effet de champ selon l'une quelconque des revendications précédentes, comprenant :

un contact de substrat (22), pour assurer un contact électrique dudit substrat (11), ledit contact de substrat (22) générant un potentiel de contact de substrat ; et
au moins un contact de grille à semiconducteur (23) pour assurer un contact électrique de ladite au moins une couche d'isolation de grille (14), ledit contact de grille à semiconducteur (23) étant choisi de façon à avoir un type de conductivité et une densité de dopant qui produise un potentiel de contact de grille qui soit égal et opposé audit potentiel de contact de substrat, ce qui neutralise lesdits potentiels de contact de grille et de substrat.

**15.** Transistor à effet de champ selon la revendication 14, dans lequel ledit contact de grille à semiconducteur (23) comprend ledit premier matériau semiconducteur sous forme polycristalline, ayant ledit premier type de conductivité et étant dopé à ladite première densité de dopant $N_s$.

**16.** Transistor à effet de champ selon la revendication 14 ou 15, dans lequel ledit substrat semiconducteur (11) comprend du silicium monocristallin, et dans lequel ledit contact de grille (23) comprend du silicium polycristallin.

**17.** Transistor à effet de champ selon la revendication 14, 15 ou 16, dans lequel ledit contact de substrat (22) comprend une couche d'un métal sur ledit substrat (11), et dans lequel ledit au moins un contact de grille à semiconducteur (23) comprend une couche du même métal sur ledit au moins un contact de grille à semiconducteur (23).

**18.** Transistor à effet de champ selon la revendication 17, dans lequel ledit métal est l'aluminium.

**19.** Transistor à effet de champ selon la revendication 17 ou 18, dans lequel ladite première densité de dopant $N_s$ est suffisamment élevée pour former un contact ohmique avec ledit métal.

**20.** Transistor à effet de champ selon l'une quelconque des revendications précédentes, dans lequel lesdites régions de source (12) et de drain (13) ont une densité de dopant qui est suffisamment élevée pour permettre un contact ohmique avec le métal.

**21.** Transistor à effet de champ selon l'une quelconque des revendications précédentes, dans lequel la résistance desdites régions de source (12) et de drain (13) est inférieure à 200 $\Omega$ par carré.

**22.** Transistor à effet de champ selon l'une quelconque des revendications précédentes, dans lequel ladite couche d'isolation de grille (14) et ledit au moins un contact de grille (23) chevauchent légèrement lesdites régions de source et de drain se trouvant sur ladite première surface.

23. Transistor à effet de champ selon l'une quelconque des revendications précédentes, dans lequel ladite couche d'isolation de grille (14) est un oxyde dudit substrat semiconducteur (11).

24. Transistor à effet de champ selon l'une quelconque des revendications précédentes, comprenant une pluralité de canaux (15, 15a, 15b, 15c) séparés les uns des autres par des régions de rails (33, 33a, 33b).

25. Transistor à effet de champ selon la revendication 24, dans lequel lesdites régions de rail (33, 33a, 33b) comprennent des rails de diffusion fortement dopés ayant le même type de conductivité que ladite pluralité de canaux (15, 15a, 15b, 15c).

26. Transistor à effet de champ selon la revendication 24 ou 25, dans lequel le contact de grille (23a) situé le plus près dudit contact de drain (20) comprend un contact accélérateur.

27. Transistor à effet de champ selon la revendication 26, dans lequel ledit contact accélérateur (23a) est maintenu à la même tension que ledit contact de drain (20).

28. Transistor à effet de champ selon la revendication 5, dans lequel ledit au moins un canal (15) est du type N, et dans lequel ladite tension de polarisation du substrat est négative.

29. Transistor à effet de champ selon la revendication 5, dans lequel ledit au moins un canal (15) est du type P, et dans lequel ladite tension de polarisation du substrat est positive.

30. Transistor à effet de champ selon la revendication 5, 28 ou 29, dans lequel la valeur absolue de ladite tension de substrat est inférieure à 2 volts.

Figure 1A    Empty Channel Condition

Figure 1B    Half Full Channel Condition

Figure 1C    Full Channel Condition

Figure 1D    Fermi-FET at Pinch-off

Figure 2-A
EMPTY CHANNEL

Figure 2-B

HALF FULL CHANNEL

FIG.2-C   Full Channel Condition

Figure 2-D   Enhanced Channel

F = Np*/Na

Figure 3-A

F =Np*/Na

Figure 3-B

41

Figure 4A

Figure 4B

Figure 4C

Figure 4D

Figure 5A

Figure 5B

Figure 5C

Figure 6A

Figure 6B

Figure 7

Figure 8

Breakdown Voltage

Figure 9A

Figure 9B

Figure 9C

Depletion Depth - u

Kd=0.2

0.4

0.6

1.0

Na*10^16

Figure 9D

Depletion Depth - u

Kd=0.2

0.4

0.6

1.0

Na*10^16

Figure 9E

Threshold Voltage

3.0

2.0

1.5

α = 1

Vsub

0.5

Figure 9F

Figure 10A

Figure 10B

Figure 10C

Figure 10D

Gate Below Threshold

14  23

$\leftarrow W_{d0} \rightarrow$

12

$V = V_0$

13

31

$V = 0$

11

32

Figure 11A

$V_g > V_T$

15  23

14

$N^{++}$ 12

S

X

$W_d$

$N^{++}$ 13

V0

31

Depletion

32

0

11

Na

Figure 11B

Figure 12

Figure 13

Source    Gate    Accelerator    Drain
Electrode

Figure 14

Figure 15 A

Figure 15 B

14 23 Vg = 0

Nd++
12

Na+ 15

Increasing
depletion
boundary

Nd++
21

Na

11

Punch-through Crossection

Depletion
Boundaries

Figure 16A

14 23 Vg = 0

Nd++
12

15

Na+

Increasing
depletion
boundary

Nd++
21

11

Na
Punch-through Crossection

Depletion
Boundaries

Figure 16B

Figure 17

Figure 18

**Breakdown Volts**

Ei = 2.5e5
Na=5e15

Figure 19

Figure 20A

Figure 20B

L = Z = 1.0um,Na=5e15, K=2 Vsub=0, Tox=120A Yo=1682A Fermi FET

Figure 21A

L = Z = 1.0mm,Na=5e15, , Tox=120A MOSFET

Figure 21B

L = Z = 0.5mm,Na=5e15, , Tox=120A MOSFET

Figure 21C

L = Z = 0.5mm,Na=5e15, , Tox=120A Fermi FET N

Figure 21 D

L = Z = 0.5mm,Na=5e15, K=3 Tox=120A Fermi FET P

Figure 21 E

L = Z = 0.5mm,Na=5e15,  Tox=120A MOSFET P

Figure 21 F